# EUROPEAN PATENT APPLICATION

(11) **EP 2 796 857 A1**
(43) Date of publication of application: **29.10.2014**
(21) Application number: 14165587.8
(22) Date of filing: 23.04.2014
(51) Int. Cl.: G01N 21/63, B23K 31/12, G01N 25/72, G01J 3/10, G01N 21/71

(54) **Optical non-destructive inspection apparatus and optical non-destructive inspection method**

(30) Priority: 26.04.2013 JP 2013093852
(71) Applicant: JTEKT CORPORATION, Osaka-shi Osaka 542-8502 (JP)
(72) Inventor: Matsumoto, Naoki, Osaka-shi, Osaka 542-8502 (JP); Yoshida, Kouya, Osaka-shi, Osaka 542-8502 (JP); Matsumoto, Jun, Osaka-shi, Osaka 542-8502 (JP)
(74) Representative: Winter, Brandl, Fürniss, Hübner, Röss, Kaiser, Polte - Partnerschaft mbB

(57) **Abstract**

There are provided an optical non-destructive inspection apparatus and an optical non-destructive inspection method, which can inspect a measurement object such as a wire bonding portion in a broad measurable temperature range in a short time, with high reliability. The apparatus includes a focusing-collimating unit (10), a heating laser beam source (21), a heating laser beam guide unit, an infrared detector (33), an emitted-infrared guide unit, first and second correcting laser beam sources (22, 23), first and second correcting laser beam guide units, first and second correcting laser detectors (31, 32), first and second reflected laser beam guide units, and a control unit (50). The control unit (50) controls the heating laser beam source (21) and the first and second correcting laser beam sources (22, 23), measures a temperature rise characteristic that is a temperature rise state of a measurement spot (SP) based on a heating time, on the basis of a detection signal from the infrared detector (33) and detection signals from the first and second correcting laser detectors (31, 32), and determines a state of a measurement object (bonding structure (97)) based on the measured temperature rise characteristic.

## Description

### BACKGROUND OF THE INVENTION

### 1. Field of the Invention

The present invention relates to an optical non-destructive inspection apparatus and an optical non-destructive inspection method.

### 2. Description of Related Art

For example, when an electrode is bonded to a semiconductor chip by wire bonding, the electrode and a wire can be bonded using various methods and it is necessary to inspect whether the electrode and the wire are appropriately bonded to each other. Conventionally, an operator visually inspects a bonding part while the bonding part is enlarged with a microscope or the like, or extracts a predetermined sample, destroys an electrode and a wire to inspect strength thereof or the like. When the bonding part is inspected visually by an operator, reliability of inspection results is low and inspection efficiency is low, because there may be difference in a skill level among operators, or the skill level of one operator may vary due to fatigue, a physical condition, or the like. When destructive inspection is performed on an extracted sample, it is not possible to assure that all the other objects that are not samples and are not actually destroyed (all the other objects that are not extracted) are in the same state as the state of the destroyed sample.

Therefore, in a conventional technology described in Japanese Patent Application Publication No. 2011-191232 (JP 2011-191232 A), a method and an apparatus are described, which determine whether the state of wire bonding with the use of a small-diameter wire is appropriate. In the technology, in order to determine whether the state of wire bonding is appropriate in a non-contact manner on the basis of an area of a bonding part, a target position of a wire is heated with a laser beam, a small amount of an infrared light beam emitted from the heated position is measured by using a two-wavelength infrared emission thermometer, a temperature variation up to a saturated temperature is measured, a numerical value correlated with the area of the bonding part is determined on the basis of the temperature variation, and it is determined whether the bonding state is appropriate on the basis of the numerical value. In this technology, a temperature rise state until the temperature reaches the saturated temperature due to heating is measured, and infrared light beams with two different wavelengths are used to measure the temperature. Correction using the reflectance or emissivity of a measurement spot is not performed. In the method using a ratio between infrared light beams with two different wavelengths, actually, measurement accuracy and a measurable temperature range are determined depending on what wavelengths are selected as the two wavelengths of the infrared light beams.

In a technology described in Japanese Patent Application Publication No. 2008-145344 (JP 2008-145344 A), a small metal bonding part evaluation method is described, in which a bonding part is heated up to a predetermined temperature with a laser beam, a temperature falling state after stoppage of irradiation with a laser beam is measured by using a temperature-measuring infrared sensor, and it is determined whether a bonding state is appropriate on the basis of the temperature falling state. Further, a reflectance-measuring laser beam and a reflectance-measuring infrared sensor are provided, and reflectance is measured to correct the measured temperature falling state. In the technology, the result of irradiation with a reflectance-measuring laser beam is detected by using the reflectance-measuring infrared sensor. That is, in order to measure the reflectance, an object is heated with the reflectance-measuring laser beam. Thus, the object is heated with the reflectance-measuring laser beam in addition to being heated with the original heating laser beam. Accordingly, the temperature fall characteristic as the measurement result is influenced by the change in the temperature due to the reflectance-measuring laser beam. Thus, it is doubtful whether appropriate correction is performed. The time until the temperature reaches the saturated temperature during heating is generally several tens of ms, but the temperature falling time after heating is generally several tens of seconds to several minutes. Accordingly, in the technology described in JP 2008-145344 A, in which the temperature falling time is measured, the inspection time is extremely long, which is not preferable.

In another conventional technology described in Japanese Patent No. 4857422, a thermophysical property measuring method and a thermophysical property measuring apparatus are described, in which a sample is fused and floated in a high-frequency coil in a vacuum chamber, a fundamental equation of heat conduction that appropriately represents a method of measuring a thermophysical property value using laser heating is derived, and actual thermophysical property of a conductive material fused at a high temperature can be directly measured. This technology is a method in which a sample is fused and floated by using a large-scaled apparatus and cannot be applied to inspection of the state of wire bonding.

### SUMMARY OF THE INVENTION

An object of the present invention is to provide an optical non-destructive inspection apparatus and an optical non-destructive inspection method, in which a measurement object such as a wire bonding portion can be inspected in a broader measurable temperature range in a shorter time, with higher reliability.

An aspect of the present invention relates to an optical non-destructive inspection apparatus. The optical non-destructive inspection apparatus includes a focusing-collimating unit that emits parallel light, which is incident from a first side along an optical axis, from a second side, focuses the parallel light to a measurement spot set on a measurement object as a focal position, converts light, which is emitted and reflected from the measurement spot and incident from the second side, into parallel light along the optical axis, and emits the parallel light from the first side; a heating laser beam source that emits a heating laser beam for heating the measurement object without destroying the measurement object; a heating laser beam guide unit that guides the heating laser beam to the first side of the focusing-collimating unit; an infrared detector that detects an infrared light beam emitted from the measurement spot; an emitted-infrared guide unit that guides an infrared light beam with a predetermined infrared wavelength out of the parallel light emitted from the measurement spot and emitted from the first side of the focusing-collimating unit, to the infrared detector; a first correcting laser beam source that emits a first correcting laser beam having output power smaller than that of the heating laser beam, and having a first correcting laser wavelength different from a heating laser wavelength of the heating laser beam; a first correcting laser beam guide unit that guides the first correcting laser beam emitted from the first correcting laser beam source to the first side of the focusing-collimating unit; a first correcting laser detector that detects the first correcting laser beam reflected by the measurement spot; a first reflected laser beam guide unit that guides the first correcting laser beam reflected by the measurement spot and emitted from the first side of the focusing-collimating unit, to the first correcting laser detector; a second correcting laser beam source that emits a second correcting laser beam having output power smaller than that of the heating laser beam, and having a second correcting laser wavelength different from the heating laser wavelength of the heating laser beam; a second correcting laser beam guide unit that guides the second correcting laser beam emitted from the second correcting laser beam source to the first side of the focusing-collimating unit; a second correcting laser detector that detects the second correcting laser beam reflected by the measurement spot; a second reflected laser beam guide unit that guides the second correcting laser beam reflected by the measurement spot and emitted from the first side of the focusing-collimating unit, to the second correcting laser detector; and a control unit. The control unit controls the heating laser beam source, the first correcting laser beam source, and the second correcting laser beam source, measures a temperature rise characteristic based on a detection signal from the infrared detector, a detection signal from the first correcting laser detector, and a detection signal from the second correcting laser detector, and determines a state of the measurement object based on the measured temperature rise characteristic, the temperature rise characteristic being a temperature rise state of the measurement spot based on a heating time.

In this aspect, since the temperature rise characteristic of the measurement object during heating is measured, inspection can be performed in a shorter time. Further, since the correcting laser beam itself, which is reflected by the measurement spot, is detected by each correcting laser detector instead of detecting an infrared light beam due to the correcting laser beam, it is not necessary to heat the measurement object with the correcting laser beam. Accordingly, irradiation is performed with the correcting laser beam whose output is small enough not to affect heating with the heating laser beam. Therefore, the measurement result is not influenced by the change in the temperature due to the reflectance-measuring laser beam, and thus, it is possible to detect a more accurate temperature. Further, the reflectance can be more accurately determined by using the first correcting laser beam with the first correcting laser wavelength and the second correcting laser beam with the second correcting laser wavelength. Therefore, it is possible to detect a more accurate temperature.

Further, since the temperature detected by using the infrared detector is corrected based on the detection signals from the correcting laser detectors, it is possible to perform the measurement in a broader temperature range, as compared to the case in which the temperature is determined based on a ratio between infrared light beams with two different wavelengths. Further, it is possible to stably perform inspection with higher reliability without an influence of the skill level, physical condition, or the like of an operator.

According to another aspect of the present invention, in the optical non-destructive inspection apparatus according to the above-mentioned aspect, the heating laser beam guide unit includes a heating laser beam collimating unit that is disposed in vicinity of the heating laser beam source, and converts the heating laser beam emitted from the heating laser beam source into parallel light; and a heating-laser selective reflection unit that is disposed on the optical axis of the focusing-collimating unit, reflects the heating laser beam to the first side of the focusing-collimating unit, and transmits a light beam with a wavelength different from the heating laser wavelength of the heating laser beam out of the parallel light emitted and reflected from the measurement spot and emitted from the first side of the focusing-collimating unit, or a heating-laser selective reflection unit that is disposed on the optical axis of the focusing-collimating unit, transmits the heating laser beam to the first side of the focusing-collimating unit, and reflects the light beam with the wavelength different from the heating laser wavelength of the heating laser beam out of the parallel light emitted and reflected from the measurement spot and emitted from the first side of the focusing-collimating unit. In this aspect, it is possible to appropriately realize the heating laser beam guide unit.

According to yet another aspect of the present invention, in the optical non-destructive inspection apparatus according to the above-mentioned aspect, the emitted-infrared guide unit includes the heating-laser selective reflection unit; a predetermined-infrared selective reflection unit disposed in a path of parallel light that is emitted from the first side of the focusing-collimating unit and transmitted or reflected by the heating-laser selective reflection unit and has a wavelength different from the heating laser wavelength of the heating laser beam, the predetermined-infrared selective reflection unit reflecting the infrared light beam with the predetermined infrared wavelength out of the parallel light toward the infrared detector, and transmitting the parallel light with a wavelength different from the predetermined infrared wavelength, or a predetermined-infrared selective reflection unit disposed in the path of the parallel light that is emitted from the first side of the focusing-collimating unit and transmitted or reflected by the heating-laser selective reflection unit and has the wavelength different from the heating laser wavelength of the heating laser beam, the predetermined-infrared selective reflection unit transmitting the infrared light beam with the predetermined infrared wavelength out of the parallel light toward the infrared detector, and reflecting the parallel light with the wavelength different from the predetermined infrared wavelength; and an infrared focusing unit that is disposed in vicinity of the infrared detector, and focuses the infrared light beam with the predetermined infrared wavelength reflected or transmitted by the predetermined-infrared selective reflection unit, to the infrared detector, the infrared light beam with the predetermined infrared wavelength being parallel light. In this aspect, it is possible to appropriately realize the emitted-infrared guide unit.

According to yet another aspect of the present invention, in the optical non-destructive inspection apparatus according to the above-mentioned aspect, the first correcting laser beam guide unit includes a first correcting laser beam collimating unit that is disposed in vicinity of the first correcting laser beam source, and converts the first correcting laser beam emitted from the first correcting laser beam source into parallel light; a first beam splitter that reflects a light beam with the first correcting laser wavelength at a first predetermined proportion, transmits the light beam with the first correcting laser wavelength at a second predetermined proportion, and reflects or transmits the first correcting laser beam with the first correcting laser wavelength, which is emitted from the first correcting laser beam source and converted into the parallel light, toward a correcting laser selective reflection unit so that the first correcting laser beam with the first correcting laser wavelength overlaps with parallel light including the first correcting laser beam reflected from the measurement spot and reflected or transmitted by the correcting laser selective reflection unit via the heating-laser selective reflection unit and the predetermined-infrared selective reflection unit; the correcting laser selective reflection unit disposed in a path of parallel light that is reflected from the measurement spot and transmitted or reflected by the predetermined-infrared selective reflection unit and has a wavelength different from the predetermined infrared wavelength, the correcting laser selective reflection unit reflecting parallel light with the first correcting laser wavelength emitted from the first correcting laser beam source and reflected or transmitted by the first beam splitter, toward the predetermined-infrared selective reflection unit so that the parallel light with the first correcting laser wavelength overlaps with parallel light with a wavelength different from the predetermined infrared wavelength, and transmitting parallel light with a wavelength different from the first correcting laser wavelength, or the correcting laser selective reflection unit disposed in the path of the parallel light that is transmitted or reflected by the predetermined-infrared selective reflection unit and has the wavelength different from the predetermined infrared wavelength, the correcting laser selective reflection unit transmitting the parallel light with the first correcting laser wavelength emitted from the first correcting laser beam source and reflected or transmitted by the first beam splitter, toward the predetermined-infrared selective reflection unit so that the parallel light with the first correcting laser wavelength overlaps with parallel light with the wavelength different from the predetermined infrared wavelength, and reflecting the parallel light with the wavelength different from the first correcting laser wavelength; the predetermined-infrared selective reflection unit; and the heating-laser selective reflection unit. The first reflected laser beam guide unit includes the heating-laser selective reflection unit; the predetermined-infrared selective reflection unit; the correcting laser selective reflection unit; the first beam splitter; and a first reflected laser beam focusing unit that is disposed in vicinity of the first correcting laser detector, and focuses parallel light with the first correcting laser wavelength reflected from the measurement spot and transmitted or reflected by the first beam splitter in a direction different from a direction toward the first correcting laser beam source, to the first correcting laser detector. In this aspect, it is possible to appropriately realize the first correcting laser beam guide unit and the first reflected laser beam guide unit.

According to yet another aspect of the present invention, in the optical non-destructive inspection apparatus according to the above-mentioned aspect, the second correcting laser beam guide unit includes a second correcting laser beam collimating unit that is disposed in vicinity of the second correcting laser beam source, and converts the second correcting laser beam emitted from the second correcting laser beam source into parallel light; a second beam splitter that reflects a light beam with the second correcting laser wavelength at a third predetermined proportion, transmits the light beam with the second correcting laser wavelength at a fourth predetermined proportion, and reflects or transmits the second correcting laser beam with the second correcting laser wavelength, which is emitted from the second correcting laser beam source and converted into the parallel light, toward the correcting laser selective reflection unit so that the second correcting laser beam with the second correcting laser wavelength overlaps with parallel light including the second correcting laser beam reflected from the measurement spot and transmitted or reflected by the correcting laser selective reflection unit via the heating-laser selective reflection unit and the predetermined-infrared selective reflection unit; the correcting laser selective reflection unit; the predetermined-infrared selective reflection unit; and the heating-laser selective reflection unit. The second reflected laser beam guide unit includes the heating-laser selective reflection unit; the predetermined-infrared selective reflection unit; the correcting laser selective reflection unit; the second beam splitter; and a second reflected laser beam focusing unit that is disposed in vicinity of the second correcting laser detector, and focuses parallel light with the second correcting laser wavelength reflected from the measurement spot and transmitted or reflected by the second beam splitter in a direction different from a direction toward the second correcting laser beam source, to the second correcting laser detector. In this aspect, it is possible to appropriately realize the second correcting laser beam guide unit and the second reflected laser beam guide unit.

According to yet another aspect of the present invention, in the optical non-destructive inspection apparatus according to the above-mentioned aspect, the first correcting laser beam guide unit includes a first correcting laser beam collimating unit that is disposed in vicinity of the first correcting laser beam source, and converts the first correcting laser beam emitted from the first correcting laser beam source into parallel light; a first beam splitter that reflects a light beam with the first correcting laser wavelength at a first predetermined proportion, transmits the light beam with the first correcting laser wavelength at a second predetermined proportion, and reflects or transmits the first correcting laser beam with the first correcting laser wavelength, which is emitted from the first correcting laser beam source and converted into parallel light, toward a correcting laser selective reflection unit so that the first correcting laser beam with the first correcting laser wavelength overlaps with parallel light including the first correcting laser beam reflected from the measurement spot and reflected or transmitted by the correcting laser selective reflection unit via the heating-laser selective reflection unit; the correcting laser selective reflection unit disposed in a path of parallel light that is reflected from the measurement spot and transmitted or reflected by the heating-laser selective reflection unit and has a wavelength different from the heating laser wavelength, the correcting laser selective reflection unit reflecting parallel light with the first correcting laser wavelength emitted from the first correcting laser beam source and reflected or transmitted by the first beam splitter, toward the heating-laser selective reflection unit so that the parallel light with the first correcting laser wavelength overlaps with parallel light with a wavelength different from the heating laser wavelength, and transmitting parallel light with a wavelength different from the first correcting laser wavelength, or the correcting laser selective reflection unit disposed in the path of the parallel light that is reflected from the measurement spot and transmitted or reflected by the heating-laser selective reflection unit and has the wavelength different from the heating laser wavelength, the correcting laser selective reflection unit transmitting the parallel light with the first correcting laser wavelength emitted from the first correcting laser beam source and reflected or transmitted by the first beam splitter, toward the heating-laser selective reflection unit so that the parallel light with the first correcting laser wavelength overlaps with the parallel light with the wavelength different from the heating laser wavelength, and reflecting the parallel light with the wavelength different from the first correcting laser wavelength; and the heating-laser selective reflection unit. The first reflected laser beam guide unit includes the heating-laser selective reflection unit; the correcting laser selective reflection unit; the first beam splitter; and a first reflected laser beam focusing unit that is disposed in vicinity of the first correcting laser detector, and focuses parallel light with the first correcting laser wavelength reflected from the measurement spot and transmitted or reflected by the first beam splitter in a direction different from a direction toward the first correcting laser beam source, to the first correcting laser detector. In this aspect, it is possible to appropriately realize the first correcting laser beam guide unit and the first reflected laser beam guide unit.

According to yet another aspect of the present invention, in the optical non-destructive inspection apparatus according to the above-mentioned aspect, the emitted-infrared guide unit includes the heating-laser selective reflection unit; the correcting laser selective reflection unit; a predetermined-infrared selective reflection unit disposed in a path of parallel light that is emitted from the first side of the focusing-collimating unit and transmitted by the heating-laser selective reflection unit and the correcting laser selective reflection unit and has a wavelength different from the heating laser wavelength and the first correcting laser wavelength, the predetermined-infrared selective reflection unit reflecting the infrared light beam with the predetermined infrared wavelength out of the parallel light, toward the infrared detector, and transmitting parallel light with a wavelength different from the predetermined infrared wavelength; or a predetermined-infrared selective reflection unit disposed in the path of the parallel light that is emitted from the first side of the focusing-collimating unit and transmitted by the heating-laser selective reflection unit and the correcting laser selective reflection unit and has the wavelength different from the heating laser wavelength and the first correcting laser wavelength, the predetermined-infrared selective reflection unit transmitting the infrared light beam with the predetermined infrared wavelength out of the parallel light, toward the infrared detector, and reflecting the parallel light with the wavelength different from the predetermined infrared wavelength; and an infrared focusing unit that is disposed in vicinity of the infrared detector, and focuses the infrared light beam with the predetermined infrared wavelength reflected or transmitted by the predetermined-infrared selective reflection unit, to the infrared detector, the infrared light beam being parallel light. In this aspect, it is possible to appropriately realize the emitted-infrared guide unit.

According to yet another aspect of the present invention, in the optical non-destructive inspection apparatus according to the above-mentioned aspect, the second correcting laser beam guide unit includes a second correcting laser beam collimating unit that is disposed in vicinity of the second correcting laser beam source, and converts the second correcting laser beam emitted from the second correcting laser beam source into parallel light; a second beam splitter that reflects a light beam with the second correcting laser wavelength at a third predetermined proportion, transmits the light beam with the second correcting laser wavelength at a fourth predetermined proportion, and reflects or transmits the second correcting laser beam with the second correcting laser wavelength, which is emitted from the second correcting laser beam source and converted into the parallel light, toward the correcting laser selective reflection unit so that the second correcting laser beam with the second correcting laser wavelength overlaps with parallel light including the second correcting laser beam reflected from the measurement spot and transmitted or reflected by the predetermined-infrared selective reflection unit via the heating-laser selective reflection unit and the correcting laser selective reflection unit; the predetermined-infrared selective reflection unit; the correcting laser selective reflection unit; and the heating-laser selective reflection unit. The second reflected laser beam guide unit includes the heating-laser selective reflection unit; the correcting laser selective reflection unit; the predetermined-infrared selective reflection unit; the second beam splitter; and a second reflected laser beam focusing unit that is disposed in vicinity of the second correcting laser detector, and focuses parallel light with the second correcting laser wavelength transmitted or reflected by the second beam splitter in a direction different from a direction toward the second correcting laser beam source, to the second correcting laser detector. In this aspect, it is possible to appropriately realize the second correcting laser beam guide unit and the second reflected laser beam guide unit.

According to yet another aspect of the present invention, in the optical non-destructive inspection apparatus according to the above-mentioned aspect, one of the first correcting laser wavelength and the second correcting laser wavelength is set to a wavelength longer than the heating laser wavelength of the heating laser beam and the other is set to a wavelength shorter than the heating laser wavelength of the heating laser beam. In this aspect, the reflectance can be determined with higher accuracy by appropriately setting the first correcting laser wavelength and the second correcting laser wavelength.

According to yet another aspect of the present invention, in the optical non-destructive inspection apparatus according to the above-mentioned aspect, the control unit acquires the detection signal from the infrared detector while controlling the heating laser beam source so as to heat the measurement spot with the heating laser beam, acquires the detection signal from the first correcting laser detector and the detection signal from the second correcting laser detector while controlling the first correcting laser beam source and the second correcting laser beam source so as to irradiate the measurement spot with the first correcting laser beam and the second correcting laser beam, measures a reflectance of the measurement spot based on the detection signal acquired from the first correcting laser detector and the detection signal acquired from the second correcting laser detector, corrects a detected value acquired from the infrared detector based on the measured reflectance, determines a temperature based on the corrected detected value, and determines the state of the measurement object based on the temperature rise characteristic that is based on the determined temperature and the heating time.

In this aspect, the reflectance of the measurement spot is measured by detecting the first correcting laser beam and the second correcting laser beam themselves, which are reflected from the measurement spot, without performing heating with the first correcting laser beam and the second correcting laser beam. Then, the detected value from the infrared detector is corrected based on the measured reflectance, and the temperature rise characteristic is determined based on the temperature that is determined based on the corrected detected value. Thus, it is possible to determine a more accurate temperature rise characteristic. Accordingly, it is possible to stably perform the inspection with higher reliability, without an influence of the skill level, physical condition, or the like of an operator.

According to yet another aspect of the present invention, in the optical non-destructive inspection apparatus according to the above-mentioned aspect, the control unit acquires the detection signal from the first correcting laser detector and the detection signal from the second correcting laser detector while controlling the first correcting laser beam source and the second correcting laser beam source so as to irradiate the measurement spot with the first correcting laser beam and the second correcting laser beam, measures a reflectance of the measurement spot based on the detection signal acquired from the first correcting laser detector and the detection signal acquired from the second correcting laser detector, adjusts output power of the heating laser beam from the heating laser beam source based on the measured reflectance, acquires the detection signal from the infrared detector while heating the measurement spot with the heating laser beam whose output power has been adjusted, determines a temperature based on the detection signal acquired from the infrared detector, and determines the state of the measurement object based on the temperature rise characteristic that is based on the determined temperature and the heating time.

In this aspect, the reflectance of the measurement spot is measured by detecting the first correcting laser beam and the second correcting laser beam themselves, which are reflected from the measurement spot, without performing heating with the first correcting laser beam and the second correcting laser beam. Then, the output of the heating laser beam is adjusted based on the measured reflectance. Therefore, it is possible to provide energy used for heating the measurement spot more accurately, and thus, it is possible to determine a more accurate temperature rise characteristic. Accordingly, it is possible to stably perform the inspection with higher reliability, without an influence of the skill level, physical condition, or the like of an operator.

According to yet another aspect of the present invention, in the optical non-destructive inspection apparatus according to the above-mentioned aspect, the measurement object is a bonding structure including a bonding part in which two members are bonded, the measurement spot is set on a surface of one member of the two members, and the control unit determines a bonding state of the two members based on the temperature rise characteristic. In this aspect, for example, when the two members are an electrode and a wire, the optical non-destructive inspection apparatus can be appropriately used to determine the bonding state of the electrode and the wire.

According to yet another aspect of the present invention, in the optical non-destructive inspection apparatus according to the above-mentioned aspect, the bonding state of the two members to be determined is a magnitude of an area of the bonding part of the two members, and the control unit determines whether the area of the bonding part of the two members is in an allowable range, based on the temperature rise characteristic. In this aspect, for example, when the two members are an electrode and a wire, it is determined whether the area of the bonding part of the electrode and the wire is in the allowable range, based on the temperature rise characteristic. Therefore, it is possible to more appropriately determine whether the bonding state of the electrode and the wire is appropriate.

Yet another aspect of the present invention relates to an optical non-destructive inspection method, in which the optical non-destructive inspection apparatus according to any one of the above-mentioned aspects is used, and the state of the measurement object is determined by the control unit. In this aspect, it is possible to provide the optical non-destructive inspection method in which the measurement object such as a wire bonding portion can be inspected in a broader measurable temperature range in a shorter time, with higher reliability.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1A is a diagram illustrating an example of a measurement object, and FIG. 1B is a diagram illustrating an example of a state in which a wire is bonded to an electrode through wire bonding;
FIG. 2 is a diagram illustrating a configuration of an optical non-destructive inspection apparatus according to a first embodiment;
FIG. 3 is a diagram illustrating a configuration of an optical non-destructive inspection apparatus according to a second embodiment;
FIG. 4 is a diagram illustrating a configuration of an optical non-destructive inspection apparatus according to a third embodiment;
FIG. 5 is a diagram illustrating a configuration of an optical non-destructive inspection apparatus according to a fourth embodiment;
FIG. 6 is a diagram illustrating a configuration of an optical non-destructive inspection apparatus according to a fifth embodiment;
FIG. 7 is a diagram illustrating a configuration of an optical non-destructive inspection apparatus according to a sixth embodiment;
FIG. 8 is a diagram illustrating a configuration of an optical non-destructive inspection apparatus according to a seventh embodiment;
FIG. 9 is a flowchart illustrating an example of a procedure of first processing in the optical non-destructive inspection apparatus;
FIG. 10 is a diagram illustrating a reflectance characteristic;
FIG. 11 is a diagram illustrating a relationship among a wavelength of an infrared light beam, energy of the infrared light beam, and a temperature;
FIG. 12 is a diagram illustrating an example of a temperature rise characteristic based on a corrected temperature obtained by performing correction by using a reflectance;
FIG. 13 is a diagram illustrating an example in which it is determined whether an area of a bonding part is in an allowable range, using the temperature rise characteristic; and
FIG. 14 is a flowchart illustrating an example of a procedure of second processing in the optical non-destructive inspection apparatus.

### DETAILED DESCRIPTION OF EMBODIMENTS

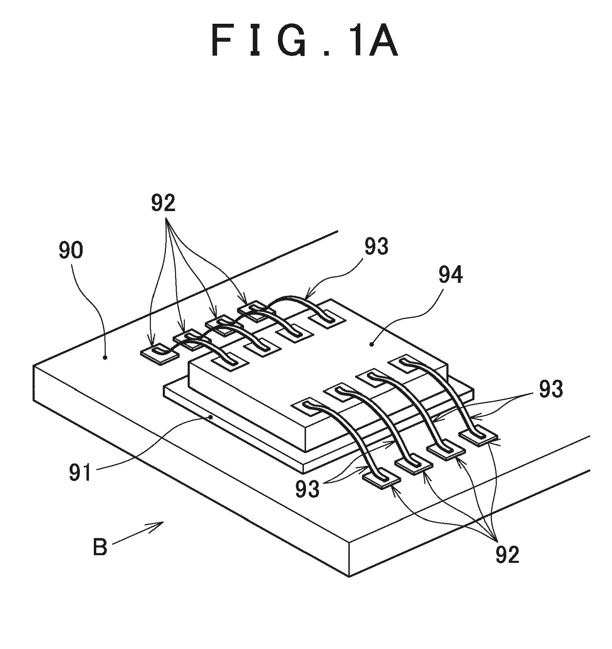

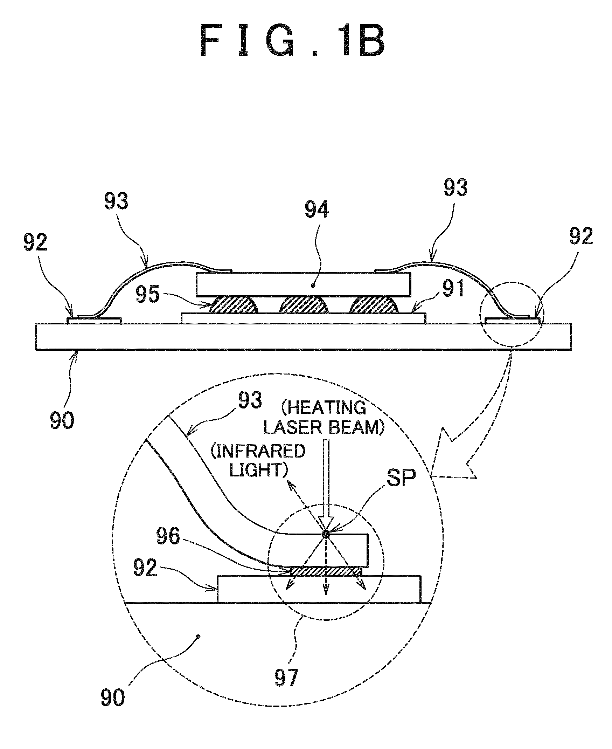

Hereinafter, embodiments of the present invention will be described with reference to the accompanying drawings. An example of a measurement object will be described with reference to FIGS. 1A and 1B. FIG. 1A is a perspective view of a board 90. A first end of a wire 93 that is formed of aluminum or the like and that has a diameter of several tens of µm to several hundreds of µm is mechanically and electrically bonded to each electrode 92 disposed on the board 90 through wire bonding, and a second end of the wire 93 is bonded to each terminal of a semiconductor chip 94 fixed onto the board 90. FIG. 1B is a view of FIG. 1A when viewed in a direction B. In this embodiment, a bonding structure 97 including a bonding part 96 in which the wire 93 and the electrode 92 are bonded to each other is described as a measurement object.

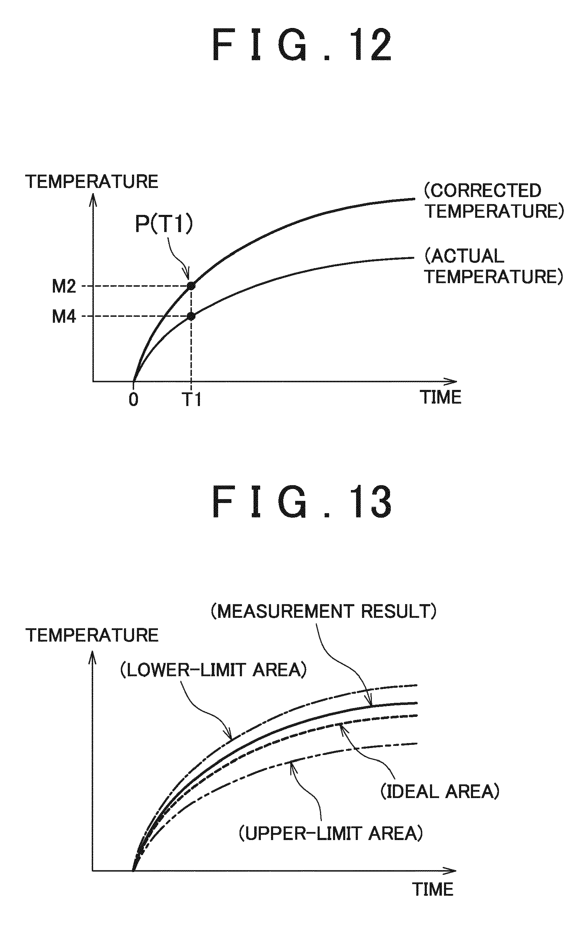

In order to determine whether the wire 93 is appropriately bonded to the electrode 92, it may be determined whether a bonding state is appropriate based on whether the area of the bonding part 96, that is, the area of a region, in which the surface of the wire 93 and the surface of the electrode 92 are parallel to each other in FIG. 1B, is in an allowable range. Therefore, as illustrated in the enlarged view of the bonding structure 97 in FIG. 1B, a measurement spot SP is set on the surface of the wire 93 of the bonding structure 97 and the measurement spot SP is irradiated and heated with a heating laser beam. Then, the temperature of the measurement spot SP gradually rises and heat transfers from the measurement spot SP to the electrode 92 via the inner portion of the wire 93 and the bonding part 96. An infrared light beam corresponding to the raised temperature is emitted from the bonding structure 97 including the measurement spot SP. The temperature of the measurement spot SP gradually rises, and when the temperature reaches a saturated temperature at which the quantity of heat added and the quantity of heat dissipated are equal to each other, the rise in temperature stops, and then, the temperature becomes substantially constant in spite of continuous heating. When the area of the bonding part 96 is relatively large, the quantity of heat transferring to the electrode 92 is large, and therefore, the temperature rises relatively gradually with the lapse of a heating time, and the saturated temperature is relatively low. When the area of the bonding part 96 is relatively small, the quantity of heat transferring to the electrode 92 is small, and therefore, the temperature rises relatively sharply with the lapse of the heating time, and the saturated temperature is raised (see FIGS. 12 and 13). Thus, it is possible to determine whether the bonding state is appropriate by irradiating the measurement spot SP with a heating laser beam, measuring the temperature rise characteristic illustrated in FIGS. 12 and 13, determining the area of the bonding part 96 on the basis of the temperature rise characteristic, and determining whether the area of the bonding part 96 is in an allowable range.

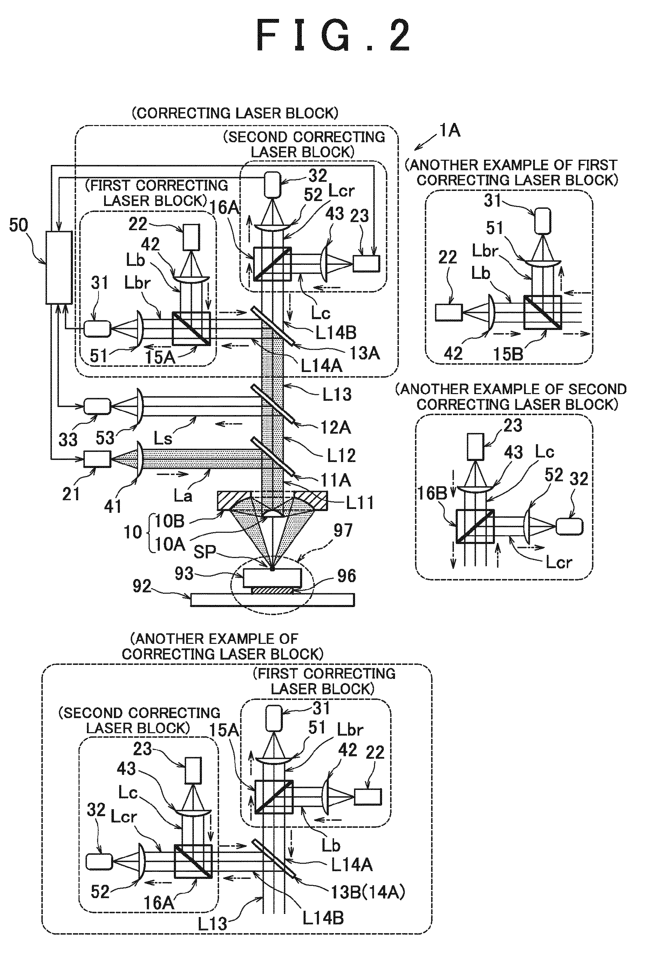

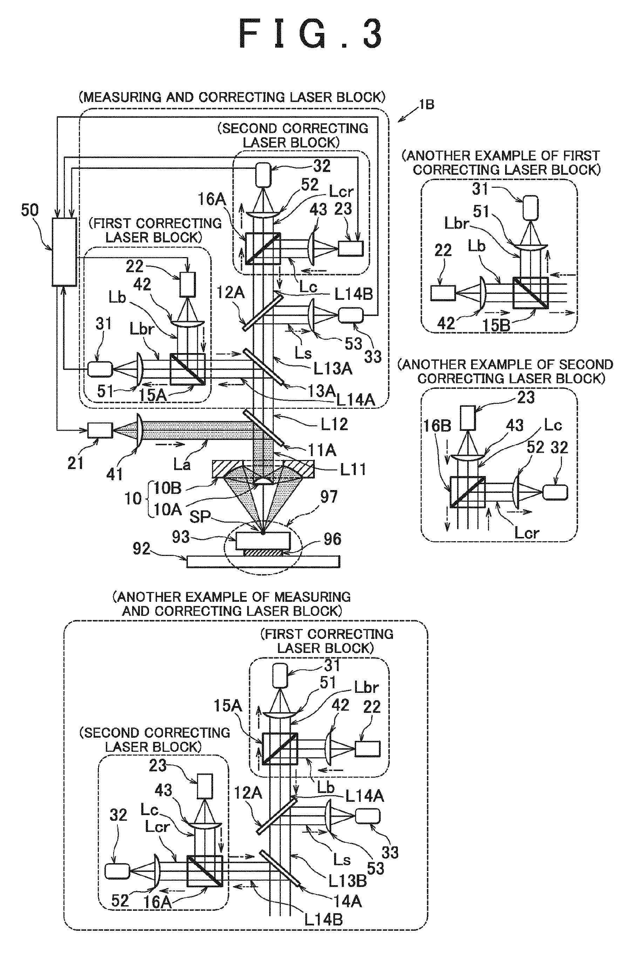

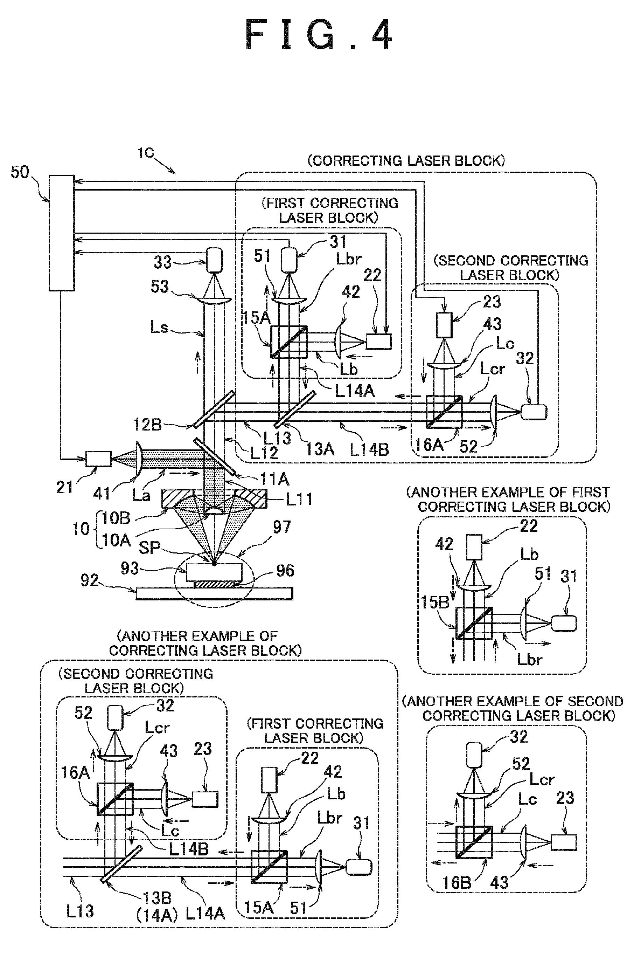

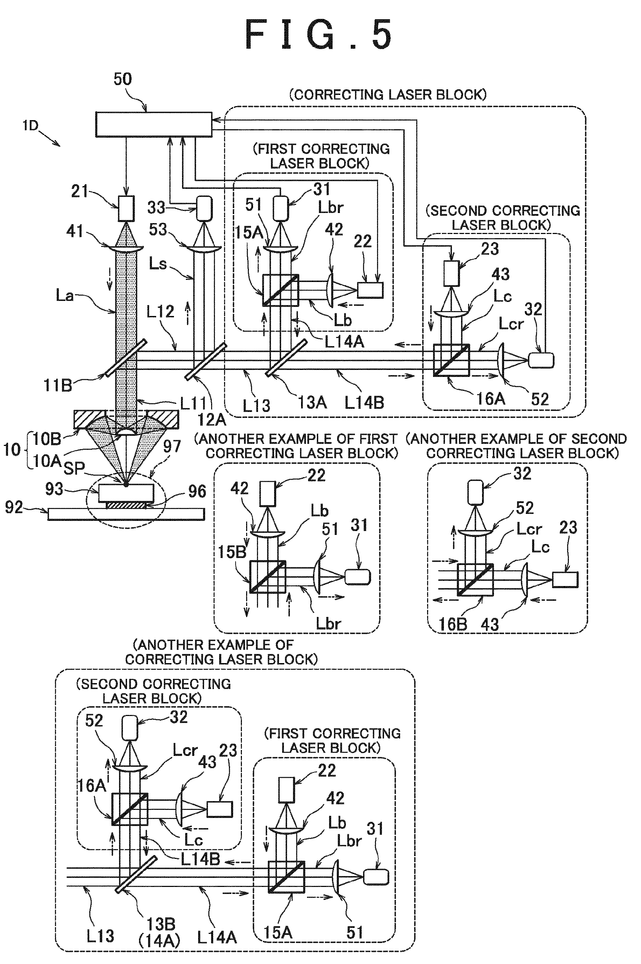

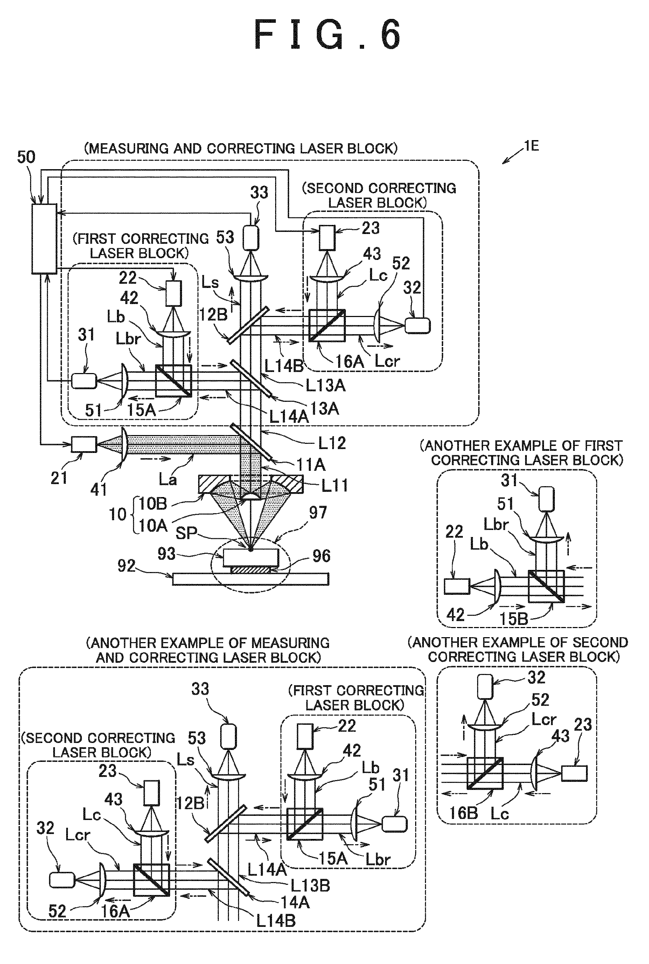

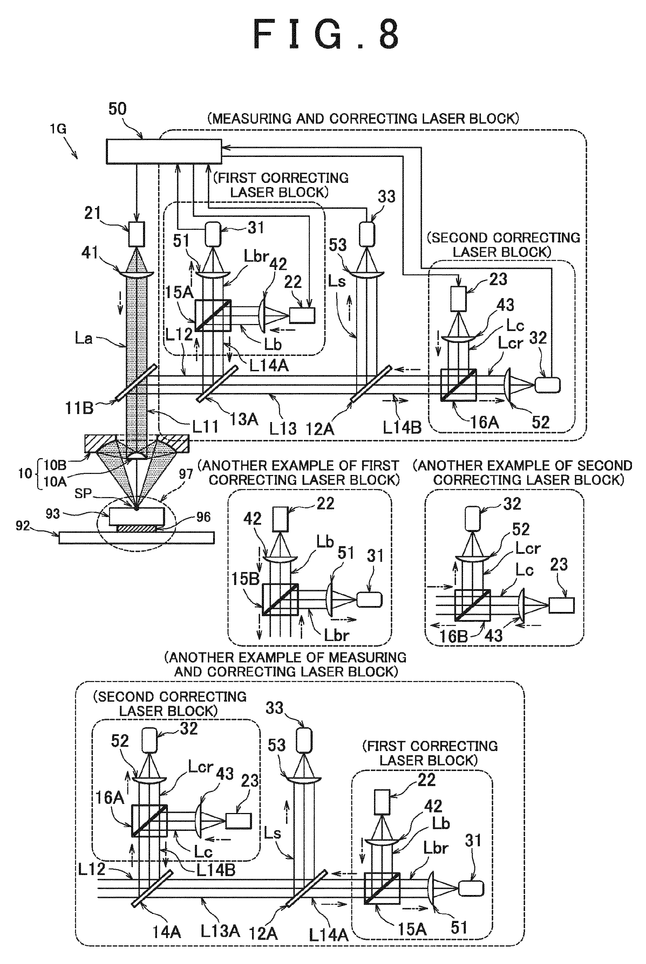

Details of optical non-destructive inspection apparatuses 1A (first embodiment) to 1G (seventh embodiment) that can determine whether the bonding state is appropriate, and optical non-destructive inspection methods thereof will be described below. In the first to seventh embodiments, arrangement positions, reflection directions, transmission directions, and the like of elements vary depending on characteristic differences of heating-laser selective reflection units 11A, 11B, predetermined-infrared selective reflection units 12A, 12B, and correcting laser selective reflection units 13A, 13B, 14A, 14B. In each of the first embodiment (FIG. 2) and the second embodiment (FIG. 3), a basic configuration of the optical non-destructive inspection apparatus in which a heating-laser selective reflection unit 11A, a predetermined-infrared selective reflection unit 12A, and a correcting laser selective reflection unit 13A are arranged on an optical axis of a focusing-collimating unit 10 is described. The first and second embodiments are different from each other in the arrangement positions of an infrared detector 33 and a first correcting laser block. The third embodiment (FIG. 4) and the fourth embodiment (FIG. 5) are described as modification examples of the first embodiment (FIG. 2). The fifth embodiment (FIG. 6) and the seventh embodiment (FIG. 8) are described as modification examples of the second embodiment (FIG. 3).

The configuration of the optical non-destructive inspection apparatus 1A according to the first embodiment will be described below with reference to FIG. 2. The optical non-destructive inspection apparatus 1A illustrated in FIG. 2 includes a focusing-collimating unit 10, a heating-laser selective reflection unit 11A, a predetermined-infrared selective reflection unit 12A, a correcting laser selective reflection unit 13A, a first beam splitter 15A, a second beam splitter 16A, a heating laser beam source 21, a heating laser beam collimating unit 41, an infrared detector 33, an infrared focusing unit 53, a first correcting laser beam source 22, a first correcting laser beam collimating unit 42, a first correcting laser detector 31, a first reflected laser beam focusing unit 51, a second correcting laser beam source 23, a second correcting laser beam collimating unit 43, a second correcting laser detector 32, a second reflected laser beam focusing unit 52, and a control unit 50.

The heating-laser selective reflection unit 11A is, for example, a dichroic mirror that reflects a light beam with a heating laser wavelength λa and that transmits a light beam with a wavelength different from the heating laser wavelength λa. The predetermined-infrared selective reflection unit 12A is, for example, a dichroic mirror that reflects a light beam with a predetermined infrared wavelength λ1 and that transmits a light beam with a wavelength different from the predetermined infrared wavelength λ1. The correcting laser selective reflection unit 13A is, for example, a dichroic mirror that reflects a light beam with a first correcting laser wavelength λb and that transmits a light beam with a wavelength different from the first correction laser wavelength λb.

The focusing-collimating unit 10 emits parallel light, which is incident from a first side (the upper side in FIG. 2) along its own optical axis, from a second side (the lower side in FIG. 2) and focuses the parallel light to the measurement spot SP set on the measurement object as a focal position. The focusing-collimating unit 10 converts light emitted and reflected from the measurement spot SP and incident from the second side, into parallel light along the optical axis and emits the parallel light from the first side. The focusing-collimating unit 10 may be formed by using a focusing lens that transmits and refracts light. However, since light beams with plural different wavelengths are treated, a focusing lens causing chromatic aberration is not preferable. Therefore, by forming the focusing-collimating unit 10 using aspheric reflecting mirrors 10A and 10B, occurrence of chromatic aberration is prevented to cope with a broad wavelength band.

The heating laser beam source 21 emits a heating laser beam, whose output level is adjusted so that the heating laser beam heats the measurement object without destroying the measurement object, on the basis of a control signal from the control unit 50. The wavelength of the heating laser beam is referred to as a heating laser wavelength λa. For example, the heating laser beam source 21 is a semiconductor laser.

The heating laser beam collimating unit 41 is disposed in the vicinity of the heating laser beam source 21, that is, in the vicinity of a laser beam emission position at a position on the optical axis of the heating laser beam, and converts the heating laser beam emitted from the heating laser beam source 21 into a heating laser beam La that is parallel light. For example, the heating laser beam collimating unit 41 needs to convert only a light beam with the heating laser wavelength λa into parallel light and thus may be a collimation lens. When the heating laser beam source 21 can emit the heating laser beam as parallel light, the heating laser beam collimating unit 41 may be omitted.

The heating-laser selective reflection unit 11A is disposed on the optical axis of the focusing-collimating unit 10 and reflects the heating laser beam La, which is obtained by converting the heating laser beam emitted from the heating laser beam source 21 into parallel light, to the first side of the focusing-collimating unit 10. The wavelength of the heating laser beam La is the heating laser wavelength λa. The heating-laser selective reflection unit 11A transmits the light beam with a wavelength different from the heating laser wavelength λa out of the parallel light emitted and reflected from the measurement spot SP and emitted from the first side of the focusing-collimating unit 10. A heating laser beam guide unit is constituted by the heating laser beam collimating unit 41 and the heating-laser selective reflection unit 11A, and the heating laser beam guide unit converts the heating laser beam emitted from the heating laser beam source 21 into parallel light and guides the parallel light to the first side of the focusing-collimating unit 10.

The infrared detector 33 can detect energy of an infrared light beam emitted from the measurement spot SP. For example, the infrared detector 33 is an infrared sensor. The detection signal from the infrared detector 33 is acquired by the control unit 50.

A predetermined-infrared selective reflection unit 12A is disposed in the path of the parallel light L12 emitted from the first side of the focusing-collimating unit 10 and transmitted by the heating-laser selective reflection unit 11A, and is disposed on the optical axis of the focusing-collimating unit 10 in this embodiment. The parallel light L12 is parallel light having a wavelength different from the heating laser wavelength λa. The predetermined-infrared selective reflection unit 12A reflects parallel light Ls that is an infrared light beam with a predetermined infrared wavelength λ1 out of the parallel light L12 emitted from first side of the focusing-collimating unit 10 and transmitted by the heating-laser selective reflection unit 11A, toward the infrared detector 33, and transmits parallel light L13 with a wavelength different from the predetermined infrared wavelength λ1. Therefore, the infrared detector 33 detects only energy of the infrared light beam with the predetermined infrared wavelength λ1.

The infrared focusing unit 53 is disposed in the vicinity of the infrared detector 33 and focuses parallel light Ls that is an infrared light beam with the predetermined infrared wavelength λ1 reflected from the predetermined-infrared selective reflection unit 12A, to a detection position of the infrared detector 33. For example, since the infrared focusing unit 53 needs to focus only the light beam with the predetermined infrared wavelength λ1, the infrared focusing unit 53 may be a focusing lens. An emitted-infrared guide unit is constituted by the heating-laser selective reflection unit 11A, the predetermined-infrared selective reflection unit 12A, and the infrared focusing unit 53. The emitted-infrared guide unit extracts the infrared light beam with the predetermined infrared wavelength λ1 out of the parallel light emitted from the measurement spot SP and emitted from the first side of the focusing-collimating unit 10 and guides the extracted infrared light beam to the infrared detector 33.

The first correcting laser beam source 22 emits a first correcting laser beam with the first correcting laser wavelength λb on the basis of a control signal from the control unit 50. For example, the first correcting laser beam source 22 is a semiconductor laser. The output power of the first correcting laser beam is adjusted to output power sufficiently smaller than that of the heating laser beam. The output power of the first correcting laser beam source 22 is adjusted so that the temperature to which the measurement spot SP is heated with the first correcting laser beam does not affect the temperature to which the measurement spot SP is heated with the heating laser beam. The first correcting laser wavelength λb is a wavelength different from the heating laser wavelength λa and a second correcting laser wavelength λc.

The first correcting laser beam collimating unit 42 is disposed on an optical axis of the first correcting laser beam at a position in the vicinity of the first correcting laser beam source 22, that is, in the vicinity of a laser beam emission position, and converts the first correcting laser beam emitted from the first correcting laser beam source 22 into parallel light Lb. For example, since the first correcting laser beam collimating unit 42 needs to convert only the light beam with the first correcting laser wavelength λb into parallel light, the first correcting laser beam collimating unit 42 may be a collimating lens. When the first correcting laser beam source 22 can emit the first correcting laser beam as parallel light, the first correcting laser beam collimating unit 42 may be omitted.

The first beam splitter 15A reflects the light beam with the first correcting laser wavelength λb emitted from the first correcting laser beam source 22, that is, the first correcting laser beam at a first predetermined proportion, and transmits the first correcting laser beam at a second predetermined proportion. The first beam splitter 15A reflects the first correcting laser beam with the first correcting laser wavelength λb emitted from the first correcting laser beam source 22 and converted into the parallel light Lb, toward the correcting laser selective reflection unit 13A at the first predetermined proportion so that the first correcting laser beam overlaps with parallel light L14A. The parallel light L14A is light obtained as a result of the first correcting laser beam being reflected from the measurement spot and reflected by the correcting laser selective reflection unit 13A, via the heating-laser selective reflection unit 11A and the predetermined-infrared selective reflection unit 12A. The first correcting laser beam at the second predetermined proportion emitted from the first correcting laser beam source 22 and transmitted by the first beam splitter 15A is not used at all and is discarded.

The correcting laser selective reflection unit 13A is disposed in a path of parallel light L13 reflected from the measurement spot and transmitted by the predetermined-infrared selective reflection unit 12A. The parallel light L13 is light with a wavelength different from the predetermined infrared wavelength λ1. The correcting laser selective reflection unit 13A reflects parallel light L14A with the first correcting laser wavelength λb emitted from the first correcting laser beam source 22 and reflected by the first beam splitter 15A, toward the predetermined-infrared selective reflection unit 12A so that the parallel light L14A overlaps with the parallel light L13, and transmits parallel light with a wavelength different from the first correcting laser wavelength λb.

A first correcting laser beam guide unit is constituted by the first correcting laser beam collimating unit 42, the first beam splitter 15A, the correcting laser selective reflection unit 13A, the predetermined-infrared selective reflection unit 12A, and the heating-laser selective reflection unit 11A. The first correcting laser beam guide unit converts the first correcting laser beam emitted from the first correcting laser beam source 22 into parallel light and guides the parallel light to the first side of the focusing-collimating unit 10.

The first correcting laser detector 31 can detect energy of the first correcting laser beam reflected from the measurement spot SP. For example, the first correcting laser detector 31 is an optical sensor that can detect energy of the light beam with the first correcting laser wavelength λb. The detection signal from the first correcting laser detector 31 is acquired by the control unit 50. The first beam splitter 15A transmits the parallel light L14A, which is reflected from the measurement spot SP, transmitted by the heating-laser selective reflection unit 11A and the predetermined-infrared selective reflection unit 12A, and reflected by the correcting laser selective reflection unit 13A, toward the first correcting laser detector 31 at the second predetermined proportion.

The first reflected laser beam focusing unit 51 is disposed in the vicinity of the first correcting laser detector 31. The first reflected laser beam focusing unit 51 focuses parallel light Lbr with the first correcting laser wavelength λb to the detection position of the first correcting laser detector 31. The parallel light Lbr is light obtained as a result of the first correcting laser beam being reflected from the measurement spot SP, transmitted by the first beam splitter 15A, and guided in a direction different from a direction toward the first correcting laser beam source 22. Reflected light of the first correcting laser beam, which is reflected from the measurement spot SP and reflected by the first beam splitter 15A, is not used at all and is discarded. Since the first reflected laser beam focusing unit 51 needs to focus only the light beam with the first correcting laser wavelength λb, the first reflected laser beam focusing unit 51 can be, for example, a focusing lens.

A first reflected laser beam guide unit is constituted by the heating-laser selective reflection unit 11A, the predetermined-infrared selective reflection unit 12A, the correcting laser selective reflection unit 13A, the first beam splitter 15A, and the first reflected laser beam focusing unit 51. The first reflected laser beam guide unit guides the first correcting laser beam reflected from the measurement spot SP and emitted from the first side of the focusing-collimating unit 10, to the first correcting laser detector 31.

The second correcting laser beam source 23 emits a second correcting laser beam with the second correcting laser wavelength λc, which is adjusted so that the output power of the second correcting laser beam is sufficiently smaller than that of the heating laser beam, on the basis of a control signal from the control unit 50. For example, the second correcting laser beam source 23 is a semiconductor laser. The output power of the second correcting laser beam source 23 is adjusted so that the temperature to which the measurement spot SP is heated with the second correcting laser beam does not affect the temperature to which the measurement spot is heated with the heating laser beam. The second correcting laser wavelength λc is a wavelength different from the heating laser wavelength λa and the first correcting laser wavelength λb.

The second correcting laser beam collimating unit 43 is disposed on an optical axis of the second correcting laser beam at a position in the vicinity of the second correcting laser beam source 23, that is, in the vicinity of a laser beam emission position, and converts the second correcting laser beam emitted from the second correcting laser beam source 23 into parallel light Lc. For example, since the second correcting laser beam collimating unit 43 needs to convert only the light beam with the second correcting laser wavelength λc into parallel light, the second correcting laser beam collimating unit 43 may be a collimating lens. When the second correcting laser beam source 23 can emit the second correcting laser beam as parallel light, the second correcting laser beam collimating unit 43 may be omitted.

The second beam splitter 16A reflects the light beam with the second correcting laser wavelength λc emitted from the second correcting laser beam source 23, that is, the second correcting laser beam, at a third predetermined proportion, and transmits the second correcting laser beam at a fourth predetermined proportion. The second beam splitter 16A reflects the second correcting laser beam with the second correcting laser wavelength λc emitted from the second correcting laser beam source 23 and converted into the parallel light Lc, toward the correcting laser selective reflection unit 13A at the third predetermined proportion so that the second correcting laser beam overlaps with the parallel light L14B. The parallel light L14B is light obtained as a result of the second correcting laser beam being reflected from the measurement spot and transmitted by the correcting laser selective reflection unit 13A, via the heating-laser selective reflection unit 11A and the predetermined-infrared selective reflection unit 12A. The second correcting laser beam at the fourth predetermined proportion emitted from the second correcting laser beam source 23 and transmitted by the second beam splitter 16A is not used at all and is discarded.

The correcting laser selective reflection unit 13A transmits the parallel light L14B with the second correcting laser wavelength λc emitted from the second correcting laser beam source 23 and reflected by the second beam splitter 16A, toward the predetermined-infrared selective reflection unit 12A so that the parallel light L14B overlaps with the parallel light L13 with a wavelength different from the predetermined infrared wavelength λ1. A second correcting laser beam guide unit is constituted by the second correcting laser beam collimating unit 43, the second beam splitter 16A, the correcting laser selective reflection unit 13A, the predetermined-infrared selective reflection unit 12A, and the heating-laser selective reflection unit 11A. The second correcting laser beam guide unit converts the second correcting laser beam emitted from the second correcting laser beam source 23 into parallel light and guides the parallel light to the first side of the focusing-collimating unit 10.

The second correcting laser detector 32 can detect energy of the second correcting laser beam reflected from the measurement spot SP. For example, the second correcting laser detector 32 is an optical sensor that can detect energy of the light beam with the second correcting laser wavelength λc. The detection signal from the second correcting laser detector 32 is acquired by the control unit 50. The second beam splitter 16A transmits the parallel light L14B obtained as a result of the second correcting laser beam being reflected from the measurement spot SP, transmitted by the heating-laser selective reflection unit 11A and the predetermined-infrared selective reflection unit 12A, and transmitted by the correcting laser selective reflection unit 13A, toward the second correcting laser detector 32 at the fourth predetermined proportion.

The second reflected laser beam focusing unit 52 is disposed in the vicinity of the second correcting laser detector 32. The second reflected laser beam focusing unit 52 focuses parallel light Lcr with the second correcting laser wavelength λc to the detection position of the second correcting laser detector 32. The parallel light Lcr is light obtained as a result of the second correcting laser beam being reflected from the measurement spot SP, transmitted by the second beam splitter 16A, and guided in a direction different from a direction toward the second correcting laser beam source 23. Reflected light of the second correcting laser beam, which is reflected from the measurement spot SP and reflected by the second beam splitter 16A, is not used at all and is discarded. Since the second reflected laser beam focusing unit 52 needs to focus only the light beam with the second correcting laser wavelength λc, the second reflected laser beam focusing unit 52 may be, for example, a focusing lens.

A second reflected laser beam guide unit is constituted by the heating-laser selective reflection unit 11A, the predetermined-infrared selective reflection unit 12A, the correcting laser selective reflection unit 13A, the second beam splitter 16A, and the second reflected laser beam focusing unit 52. The second reflected laser beam guide unit guides the second correcting laser beam reflected from the measurement spot SP and emitted from the first side of the focusing-collimating unit 10, to the second correcting laser detector 32.

The control unit 50 is constituted by a personal computer or the like, controls the heating laser beam source 21, the first correcting laser beam source 22, and the second correcting laser beam source 23, and measures a temperature rise characteristic that is a temperature rise state of the measurement spot SP based on a heating time, on the basis of the detection signal from the infrared detector 33, the detection signal from the first correcting laser detector 31, and the detection signal from the second correcting laser detector 32. The control unit 50 determines the state of the measurement object on the basis of the measured temperature rise characteristic. Detailed operations of the control unit 50 will be described later.

The "first correcting laser block" in FIG. 2 may be configured as illustrated in "another example of first correcting laser block". In this case, the first beam splitter 15B transmits the light beam with the first correcting laser wavelength λb emitted from the first correcting laser beam source 22, at the first predetermined proportion, and reflects the light beam with the first correcting laser wavelength λb at the second predetermined proportion.

The "second correcting laser block" in FIG. 2 may be configured as illustrated in "another example of second correcting laser block". In this case, the second beam splitter 16B transmits the light beam with the second correcting laser wavelength λc emitted from the second correcting laser beam source 23, at the third predetermined proportion, and reflects the light beam with the second correcting laser wavelength λc at the fourth predetermined proportion.

The "correcting laser block" in FIG. 2 may be configured as illustrated in "another example of correcting laser block". In this case, the correcting laser selective reflection unit 13B transmits the light beam with the first correcting laser wavelength λb and reflects the light beam with a wavelength different from the first correcting laser wavelength λb. A correcting laser selective reflection unit 14A that reflects the light beam with the second correcting laser wavelength λc and transmits the light beam with a wavelength different from the second correcting laser wavelength λc may be used instead of the correcting laser selective reflection unit 13B.

The configuration of the optical non-destructive inspection apparatus 1B according to the second embodiment will be described below with reference to FIG. 3. The optical non-destructive inspection apparatus 1B according to the second embodiment is different from the optical non-destructive inspection apparatus 1A according to the first embodiment, in that the arrangement positions of the predetermined-infrared selective reflection unit 12A, the infrared focusing unit 53, and the infrared detector 33 and the arrangement positions of the correcting laser selective reflection unit 13A, the first beam splitter 15A, the first correcting laser beam collimating unit 42, the first correcting laser beam source 22, the first reflected laser beam focusing unit 51, and the first correcting laser detector 31 are switched to each other, that is, in that the positions of the predetermined-infrared selective reflection unit 12A, the infrared focusing unit 53, and the infrared detector 33 and the positions of the correcting laser selective reflection unit 13A, the first beam splitter 15A, the first correcting laser beam collimating unit 42, the first correcting laser beam source 22, the first reflected laser beam focusing unit 51, and the first correcting laser detector 31 in the vertical direction in FIGS. 2 and 3 are switched to each other. Therefore, the optical non-destructive inspection apparatus 1B according to the second embodiment have the same elements as in the first optical non-destructive inspection apparatus 1A according to the first embodiment but is different from the optical non-destructive inspection apparatus 1A in only the arrangement positions of some elements. Differences from the optical non-destructive inspection apparatus 1A according to the first embodiment will be described mainly.

The correcting laser selective reflection unit 13A is disposed in a path of parallel light L12 with a wavelength different from the heating laser wavelength λa, which is reflected from the measurement spot and transmitted by the heating-laser selective reflection unit 11A. The correcting laser selective reflection unit 13A reflects parallel light with the first correcting laser wavelength λb emitted from the first correcting laser beam source 22 and reflected by the first beam splitter 15A, toward the heating-laser selective reflection unit 11A so that the parallel light with the first correcting laser wavelength λb overlaps with the parallel light L12 with a wavelength different from the heating laser wavelength λa. The correcting laser selective reflection unit 13A transmits a light beam with a wavelength different from the first correcting laser wavelength λb.

The first beam splitter 15A reflects the light beam with the first correcting laser wavelength λb at the first predetermined proportion and transmits the light beam with the first correcting laser wavelength λb at the second predetermined proportion. The first beam splitter 15A reflects the first correcting laser beam with the first correcting laser wavelength λb emitted from the first correcting laser beam source 22 and converted into the parallel light, toward the correcting laser selective reflection unit 13A so that the first correcting laser beam overlaps with the parallel light L14A. The parallel light L14A is light obtained as a result of the first correcting laser beam being reflected from the measurement spot and reflected by the correcting laser selective reflection unit 13A, via the heating-laser selective reflection unit 11A.

A first correcting laser beam guide unit is constituted by the first correcting laser beam collimating unit 42, the first beam splitter 15A, the correcting laser selective reflection unit 13A, and the heating-laser selective reflection unit 11A. The first correcting laser beam guide unit converts the first correcting laser beam emitted from the first correcting laser beam source 22 into parallel light, and guides the parallel light to the first side of the focusing-collimating unit 10. A first reflected laser beam guide unit is constituted by the heating-laser selective reflection unit 11A, the correcting laser selective reflection unit 13A, the first beam splitter 15A, and the first reflected laser beam focusing unit 51. The first reflected laser beam guide unit guides the first correcting laser beam reflected from the measurement spot SP and emitted from the first side of the focusing-collimating unit 10, toward the first correcting laser detector 31.

The predetermined-infrared selective reflection unit 12A is disposed in a path of the parallel light L13A. The parallel light L13A is light with a wavelength different from the heating laser wavelength λa and the first correcting laser wavelength λb, which is emitted from the first side of the focusing-collimating unit 10 and transmitted by the heating-laser selective reflection unit 11A and the correcting laser selective reflection unit 13A. The predetermined-infrared selective reflection unit 12A reflects the infrared light beam with the predetermined infrared wavelength λ1 out of the parallel light L13A, toward the infrared detector 33 and transmits parallel light L14B with a wavelength different from the predetermined infrared wavelength λ1.

The emitted-infrared guide unit is constituted by the heating-laser selective reflection unit 11A, the correcting laser selective reflection unit 13A, the predetermined-infrared selective reflection unit 12A, and the infrared focusing unit 53. The emitted-infrared guide unit guides the infrared light beam with the predetermined infrared wavelength λ1 out of the parallel light emitted from the measurement spot SP and emitted from the first side of the focusing-collimating unit 10, to the infrared detector 33.

The second beam splitter 16A reflects the light beam with the second correcting laser wavelength λc at the third predetermined proportion, transmits the light beam with the second correcting laser wavelength λc at the fourth predetermined proportion, and reflects the second correcting laser beam with the second correcting laser wavelength λc emitted from the second correcting laser beam source 23 and converted into the parallel light Lc, toward the predetermined-infrared selective reflection unit 12A so that the second correcting laser beam overlaps with the parallel light L14B. The parallel light L14B is light reflected from the measurement spot and transmitted by the predetermined-infrared selective reflection unit 12A, via the heating-laser selective reflection unit 11A and the correcting laser selective reflection unit 13A. The parallel light L14B includes the second correcting laser beam.

A second correcting laser beam guide unit is constituted by the second correcting laser beam collimating unit 43, the second beam splitter 16A, the predetermined-infrared selective reflection unit 12A, the correcting laser selective reflection unit 13A, and the heating-laser selective reflection unit 11A. The second correcting laser beam guide unit converts the second correcting laser beam emitted from the second correcting laser beam source 23 into parallel light, and guides the parallel light to the first side of the focusing-collimating unit 10.

A second reflected laser beam guide unit is constituted by the heating-laser selective reflection unit 11A, the correcting laser selective reflection unit 13A, the predetermined-infrared selective reflection unit 12A, the second beam splitter 16A, and the second reflected laser beam focusing unit 52. The second reflected laser beam guide unit guides the second correcting laser beam reflected from the measurement spot SP and emitted from the first side of the focusing-collimating unit 10, to the second correcting laser detector 32.

The "first correcting laser block" in FIG. 3 may be configured as illustrated in "another example of first correcting laser block". In this case, the first beam splitter 15B transmits the light beam with the first correcting laser wavelength λb emitted from the first correcting laser beam source 22, at the first predetermined proportion, and reflects the light beam with the first correcting laser wavelength λb at the second predetermined proportion.

The "second correcting laser block" in FIG. 3 may be configured as illustrated in "another example of second correcting laser block". In this case, the second beam splitter 16B transmits the light beam with the second correcting laser wavelength λc emitted from the second correcting laser beam source 23, at the third predetermined proportion, and reflects the light beam with the second correcting laser wavelength λc at the fourth predetermined proportion.

The "measuring and correcting laser block" in FIG. 3 may be configured as illustrated in "another example of measuring and correcting laser block". In this case, the correcting laser selective reflection unit 14A reflects the light beam with the second correcting laser wavelength λc and transmits the light beam with a wavelength different from the second correcting laser wavelength λc.

The configuration of the optical non-destructive inspection apparatus 1C according to the third embodiment will be described below with reference to FIG. 4. The optical non-destructive inspection apparatus 1C according to the third embodiment is different from the optical non-destructive inspection apparatus 1A according to the first embodiment, in the operation of the predetermined-infrared selective reflection unit 12B. However, in the optical non-destructive inspection apparatus 1C according to the third embodiment, the path subsequent to the predetermined-infrared selective reflection unit 12B and the path prior to the predetermined-infrared selective reflection unit 12B in the path of light reflected and emitted from the measurement spot are the same as those in the optical non-destructive inspection apparatus 1A according to the first embodiment. Differences from the optical non-destructive inspection apparatus 1A according to the first embodiment will be mainly described.

The predetermined-infrared selective reflection unit 12B is disposed in the path of parallel light L12 with a wavelength different from the heating laser wavelength λa, which is emitted from the first side of the focusing-collimating unit 10 and transmitted by the heating-laser selective reflection unit 11A. The predetermined-infrared selective reflection unit 12B transmits the infrared light beam with the predetermined infrared wavelength λ1 out of the parallel light L12, toward the infrared detector 33, and reflects parallel light with a wavelength different from the predetermined infrared wavelength λ1. The reflected parallel light is parallel light L13 in FIG. 4.

The "first correcting laser block" in FIG. 4 may be configured as illustrated in "another example of first correcting laser block". In this case, the first beam splitter 15B transmits the light beam with the first correcting laser wavelength λb emitted from the first correcting laser beam source 22, at the first predetermined proportion, and reflects the light beam with the first correcting laser wavelength λb at the second predetermined proportion.

The "second correcting laser block" in FIG. 4 may be configured as illustrated in "another example of second correcting laser block". In this case, the second beam splitter 16B transmits the light beam with the second correcting laser wavelength λc emitted from the second correcting laser beam source 23, at the third predetermined proportion, and reflects the light beam with the second correcting laser wavelength λc at the fourth predetermined proportion.

The "correcting laser block" in FIG. 4 may be configured as illustrated in "another example of correcting laser block". In this case, the correcting laser selective reflection unit 13B transmits the light beam with the first correcting laser wavelength λb and reflects the light beam with a wavelength different from the first correcting laser wavelength λb. A correcting laser selective reflection unit 14A that reflects the light beam with the second correcting laser wavelength λc and that transmits the light beam with a wavelength different from the second correcting laser wavelength λc may be used instead of the correcting laser selective reflection unit 13B.

The configuration of the optical non-destructive inspection apparatus 1D according to the fourth embodiment will be described below with reference to FIG. 5. The optical non-destructive inspection apparatus 1D according to the fourth embodiment is different from the optical non-destructive inspection apparatus 1A according to the first embodiment, in the operation of the heating-laser selective reflection unit 11B. However, in the optical non-destructive inspection apparatus 1D according to the fourth embodiment, the path subsequent to the heating-laser selective reflection unit 11B in the path of light reflected and emitted from the measurement spot is the same as that in the optical non-destructive inspection apparatus 1A according to the first embodiment. Differences from the optical non-destructive inspection apparatus 1A according to the first embodiment will be mainly described.

The heating-laser selective reflection unit 11B is disposed on an optical axis of the focusing-collimating unit 10, transmits the heating laser beam with the heating laser wavelength λa emitted from the heating laser beam source 21 and converted into parallel light, toward the first side of the focusing-collimating unit 10, and reflects parallel light with a wavelength different from the heating laser wavelength λa emitted and reflected from the measurement spot and emitted from the first side of the focusing-collimating unit 10. The reflected parallel light is parallel light L12 in FIG. 5.

The "first correcting laser block" in FIG. 5 may be configured as illustrated in "another example of first correcting laser block". In this case, the first beam splitter 15B transmits the light beam with the first correcting laser wavelength λb emitted from the first correcting laser beam source 22, at the first predetermined proportion, and reflects the light beam with the first correcting laser wavelength λb at the second predetermined proportion. The "second correcting laser block" in FIG. 5 may be configured as illustrated in "another example of second correcting laser block". In this case, the second beam splitter 16B transmits the light beam with the second correcting laser wavelength λc emitted from the second correcting laser beam source 23, at the third predetermined proportion, and reflects the light beam with the second correcting laser wavelength λc at the fourth predetermined proportion.

The "correcting laser block" in FIG. 5 may be configured as illustrated in "another example of correcting laser block". In this case, the correcting laser selective reflection unit 13B transmits the light beam with the first correcting laser wavelength λb and reflects the light beam with a wavelength different from the first correcting laser wavelength λb. A correcting laser selective reflection unit 14A that reflects the light beam with the second correcting laser wavelength λc and that transmits the light beam with a wavelength different from the second correcting laser wavelength λc may be used instead of the correcting laser selective reflection unit 13B.

The configuration of the optical non-destructive inspection apparatus 1E according to the fifth embodiment will be described below with reference to FIG. 6. The optical non-destructive inspection apparatus 1E according to the fifth embodiment is different from the optical non-destructive inspection apparatus 1B according to the second embodiment, in the operation of the predetermined-infrared selective reflection unit 12B. However, in the optical non-destructive inspection apparatus 1E according to the fifth embodiment, the path subsequent to the predetermined-infrared selective reflection unit 12B and the path prior to the predetermined-infrared selective reflection unit 12B in the path of light reflected and emitted from the measurement spot are the same as those in the optical non-destructive inspection apparatus 1B according to the second embodiment. Differences from the optical non-destructive inspection apparatus 1B according to the second embodiment will be mainly described.

The predetermined-infrared selective reflection unit 12B is disposed in the path of parallel light L13A that is emitted from the first side of the focusing-collimating unit 10 and transmitted by the heating-laser selective reflection unit 11A and the correcting laser selective reflection unit 13A. The parallel light L13A is light with a wavelength different from the heating laser wavelength λa and the first correcting laser wavelength λb. The predetermined-infrared selective reflection unit 12B transmits the infrared light beam with the predetermined infrared wavelength λ1 out of the parallel light L13A, toward the infrared detector 33, and reflects parallel light with a wavelength different from the predetermined infrared wavelength λ1. The reflected parallel light is parallel light L14B in FIG. 6.

The "first correcting laser block" in FIG. 6 may be configured as illustrated in "another example of first correcting laser block". In this case, the first beam splitter 15B transmits the light beam with the first correcting laser wavelength λb emitted from the first correcting laser beam source 22, at the first predetermined proportion, and reflects the light beam with the first correcting laser wavelength λb at the second predetermined proportion.

The "second correcting laser block" in FIG. 6 may be configured as illustrated in "another example of second correcting laser block". In this case, the second beam splitter 16B transmits the light beam with the second correcting laser wavelength λc emitted from the second correcting laser beam source 23, at the third predetermined proportion, and reflects the light beam with the second correcting laser wavelength λc at the fourth predetermined proportion.

The "measuring and correcting laser block" in FIG. 6 may be configured as illustrated in "another example of measuring and correcting laser block". In this case, the correcting laser selective reflection unit 14A reflects the light beam with the second correcting laser wavelength λc, and transmits the light beam with a wavelength different from the second correcting laser wavelength λc.

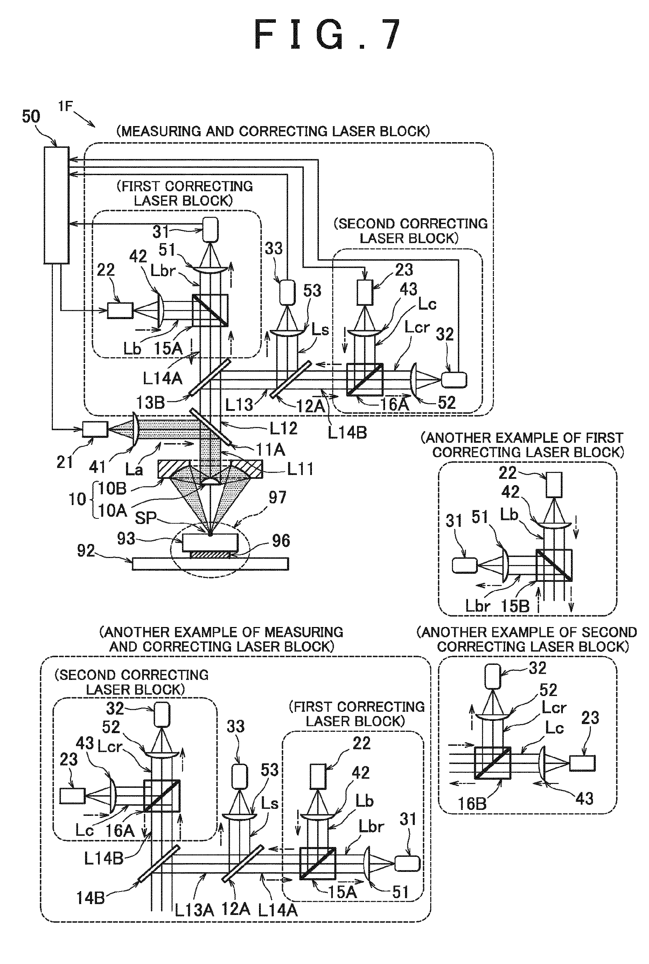

The configuration of the optical non-destructive inspection apparatus 1F according to the sixth embodiment will be described below with reference to FIG. 7. The optical non-destructive inspection apparatus 1F according to the sixth embodiment is different from the optical non-destructive inspection apparatus 1B according to the second embodiment, in the operation of the correcting laser selective reflection unit 13B. However, in the optical non-destructive inspection apparatus 1F according to the sixth embodiment, the path subsequent to the correcting laser selective reflection unit 13B and the path prior to the correcting laser selective reflection unit 13B in the path of light reflected and emitted from the measurement spot are the same as those in the optical non-destructive inspection apparatus 1B according to the second embodiment. Differences from the optical non-destructive inspection apparatus 1B according to the second embodiment will be mainly described.

The correcting laser selective reflection unit 13B is disposed in the path of parallel light L12 with a wavelength different from the heating laser wavelength λa, which is reflected from the measurement spot and transmitted by the heating-laser selective reflection unit 11A. The correcting laser selective reflection unit 13B transmits parallel light with the first correcting laser wavelength λb emitted from the first correcting laser beam source 22 and reflected by the first beam splitter 15A, toward the heating-laser selective reflection unit 11A so that the parallel light with the first correcting laser wavelength λb overlaps with the parallel light L12, and reflects parallel light with a wavelength different from the first correcting laser wavelength λb. The reflected parallel light is the parallel light L13 in FIG. 7.

The "first correcting laser block" in FIG. 7 may be configured as illustrated in "another example of first correcting laser block". In this case, the first beam splitter 15B transmits the light beam with the first correcting laser wavelength λb emitted from the first correcting laser beam source 22, at the first predetermined proportion, and reflects the light beam with the first correcting laser wavelength λb at the second predetermined proportion.

The "second correcting laser block" in FIG. 7 may be configured as illustrated in "another example of second correcting laser block". In this case, the second beam splitter 16B transmits the light beam with the second correcting laser wavelength λc emitted from the second correcting laser beam source 23, at the third predetermined proportion, and reflects the light beam with the second correcting laser wavelength λc at the fourth predetermined proportion.

The "measuring and correcting laser block" in FIG. 7 may be configured as illustrated in "another example of measuring and correcting laser block". In this case, the correcting laser selective reflection unit 14B transmits the light beam with the second correcting laser wavelength λc and reflects the light beam with a wavelength different from the second correcting laser wavelength λc.

The configuration of the optical non-destructive inspection apparatus 1G according to the seventh embodiment will be described below with reference to FIG. 8. The optical non-destructive inspection apparatus 1G according to the seventh embodiment is different from the optical non-destructive inspection apparatus 1B according to the second embodiment, in the operation of the heating-laser selective reflection unit 11B. However,
is equal to the optical non-destructive inspection apparatus 1B according to the second embodiment, in the path subsequent to the heating-laser selective reflection unit 11B out of the path of light reflected and emitted from the measurement spot. Differences from the optical non-destructive inspection apparatus 1B according to the second embodiment will be mainly described.

The heating-laser selective reflection unit 11B is disposed on the optical axis of the focusing-collimating unit 10, transmits the heating laser beam with the heating laser wavelength λa emitted from the heating laser beam source 21 and converted into parallel light, toward the first side of the focusing-collimating unit 10, and reflects parallel light with a wavelength different from the heating laser wavelength λa emitted and reflected from the measurement spot and emitted from the first side of the focusing-collimating unit 10. The reflected parallel light is parallel light L12 in FIG. 8.

The "first correcting laser block" in FIG. 8 may be configured as illustrated in "another example of first correcting laser block". In this case, the first beam splitter 15B transmits the light beam with the first correcting laser wavelength λb emitted from the first correcting laser beam source 22, at the first predetermined proportion, and reflects the light beam with the first correcting laser wavelength λb at the second predetermined proportion.

The "second correcting laser block" in FIG. 8 may be configured as illustrated in "another example of second correcting laser block". In this case, the second beam splitter 16B transmits the light beam with the second correcting laser wavelength λc emitted from the second correcting laser beam source 23, at the third predetermined proportion, and reflects the light beam with the second correcting laser wavelength λc at the fourth predetermined proportion.

The "measuring and correcting laser block" in FIG. 8 may be configured as illustrated in "another example of measuring and correcting laser block". In this case, the correcting laser selective reflection unit 14A reflects the light beam with the second correcting laser wavelength λc and transmits a light beam with a wavelength different from the second correcting laser wavelength λc.

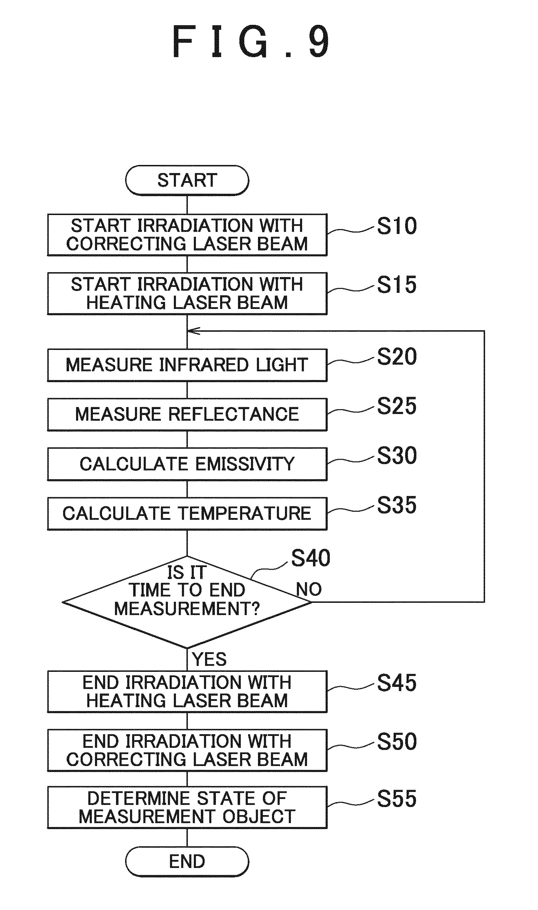

An example of the procedure of first processing performed by the control unit 50 will be described below with reference to the flowchart illustrated in FIG. 9. The configuration of the optical non-destructive inspection apparatus may be the same as that in any one of the first to seventh embodiments. The processing illustrated in FIG. 9 is performed by the control unit 50 when a measurement spot is inspected.

In step S 10, the control unit 50 controls the first correcting laser beam source and the second correcting laser beam source so that the first correcting laser beam is emitted from the first correcting laser beam source and the second correcting laser beam is emitted from the second correcting laser beam source, and then performs the process of step S 15. The first correcting laser beam and the second correcting laser beam are guided to the measurement spot, the first correcting laser beam reflected from the measurement spot is guided to the first correcting laser detector, and the second correcting laser beam reflected from the measurement spot is guided to the second correcting laser detector.

In step S15, the control unit 50 controls the heating laser beam source so that the heating laser beam is emitted from the heating laser beam source, and then performs the process of step S20. The heating laser beam is guided to the measurement spot and the infrared light beam emitted from the measurement spot is guided to the infrared detector.

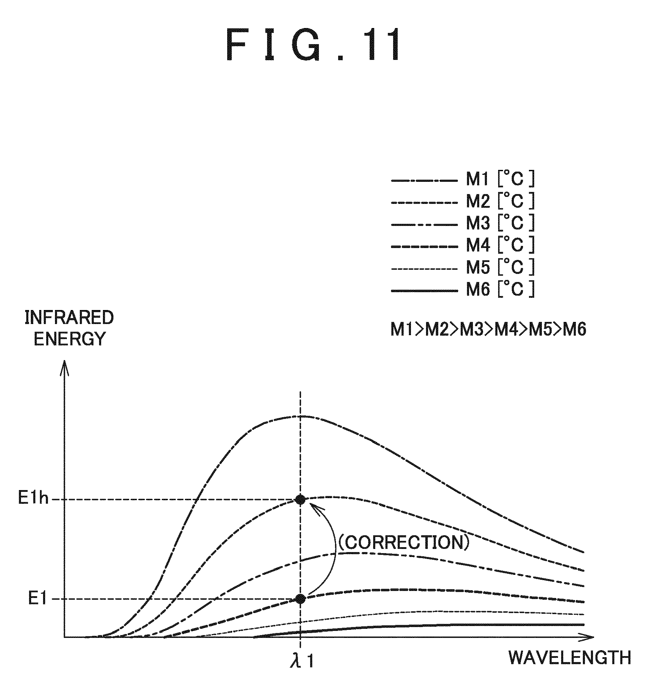

In step S20, the control unit 50 detects energy of the infrared light beam with the predetermined infrared wavelength λ1 on the basis of the detection signal from the infrared detector, acquires and temporarily stores the energy of the infrared light beam with the predetermined infrared wavelength λ1 and the time after irradiation with the heating laser beam is started in step S15, and then performs the process of step S25. FIG. 11 illustrates an example of an infrared emission characteristic representing the relationship between the wavelength of the infrared light beam radiated from a black body (indicated by the horizontal axis) and energy of the infrared light beam with the corresponding wavelength (indicated by the vertical axis) when the temperature of the black body completely absorbing and radiating irradiated light is each of temperatures (M1, M2, M3, M4, M5, and M6). For example, when the measurement spot is a black body, the position of the detected predetermined infrared wavelength λ1 is the position of λ1 illustrated in FIG. 11, and the detected energy is E1, it can be determined that the temperature of the measurement spot is M4 (°C). However, since the actual measurement spot is not a black body and thus does not absorb the whole heating laser beam and reflects a part thereof, correction needs to be performed. The energy of the infrared light beam detected in step S20 is corrected in subsequent steps S25 to S35.

In step S25, the control unit 50 measures the reflectances of the first correcting laser beam and the second correcting laser beam on the basis of the detection signal from the first correcting laser detector and the detection signal from the second correcting laser detector, and then performs the process of step S30. For example, the control unit 50 measures the reflectance of the measurement spot on the basis of the energy of the first and second correcting laser beams from the first and second correcting laser beam sources, the reflectances of the first and second beam splitters, the transmittances of the first and second beam splitters, and the energy of the light beams with the first and second correcting laser wavelengths detected by the first and the second correcting laser detectors.

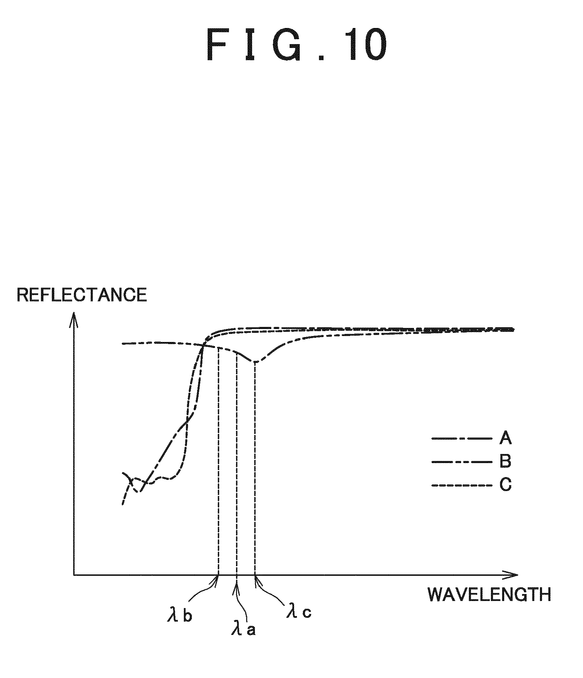

FIG. 10 illustrates an example of a reflectance characteristic representing the relationship between the wavelength (indicated by the horizontal axis) of an applied light beam and the reflectance (indicated by the vertical axis) in a material A, a material B, and a material C, each of which has a surface in a predetermined surface state. As illustrated in FIG. 10, the reflectance varies depending on the material of an object or the wavelength of the applied light beam and varies depending on the surface state (for example, density or depth of fine unevenness) of the object. Therefore, it is necessary to measure the reflectance for each measurement spot.

The first correcting laser wavelength λb and the second correcting laser wavelength λc are wavelengths different from the heating laser wavelength λa. When the wavelength λb or λc is equal to the heating laser wavelength λa, the correcting laser beams are repelled from the heating-laser selective reflection unit. Therefore, as in the example illustrated in FIG. 10, one wavelength (the first correcting laser wavelength λb in the example illustrated in FIG. 10) of the first correcting laser wavelength λb and the second correcting laser wavelength λc is set to a wavelength shorter than the heating laser wavelength λa and the other wavelength (the second correcting laser wavelength λc in the example illustrated in FIG. 10) is set to a wavelength longer than the heating laser wavelength λa. Thus, by setting the first correcting laser wavelength λb and the second correcting laser wavelength λc to appropriate values with respect to the heating laser wavelength λa, it is possible to measure more accurate reflectance. In the example illustrated in FIG. 10, by calculating [(reflectance measured with the first correcting laser wavelength) + (reflectance measured with the second correcting laser wavelength)] / 2, it is possible to calculate more accurate reflectance of the heating laser wavelength λa.

In step S30, the control unit 50 calculates emissivity from the reflectance measured in step S25, and then performs the process of step S35. Specifically, the emissivity is calculated on the basis of the relationship of emissivity (%) = absorptance (%) = 100 (%) - reflectance (%).

In step S35, the control unit 50 corrects the infrared energy (corresponding to the detected energy of the infrared light beam) temporarily stored in step S20 on the basis of the emissivity calculated in step S30 and then performs the process of step S40. For example, it is assumed that when the infrared energy temporarily stored in step S20 is E1 illustrated in FIG. 11, the result of correcting E1 using the emissivity calculated in step S30 is E1h. In this case, the correct temperature of the measurement spot is M2 (°C) (corrected temperature) corresponding to the corrected E1h instead of M4 (°C) (actual temperature) corresponding to E1. The actual temperature means a temperature based on the actually-measured infrared energy. The corrected temperature means a temperature based on the corrected infrared energy. The infrared emission characteristic shown in the example illustrated in FIG. 11 is stored in advance in a storage unit, and the control unit 50 determines the temperature (M2 (°C) in this case) of the measurement spot on the basis of the infrared emission characteristic stored in the storage unit and the detected and corrected infrared energy (the energy E1h that is the corrected detected value in this case).

Then, the control unit determines the temperature rise characteristic shown in the example illustrated in FIG. 12 on the basis of the time after the irradiation is started, which is stored in step S20, and the corrected temperature corresponding to the time. For example, a case where the time after the irradiation is started is T1, the actual temperature is M4 (°C), and the corrected temperature is M2 (°C) is illustrated in FIG. 12. The control unit needs to determine only the temperature rise characteristic based on the corrected temperature and may not particularly determine the temperature rise characteristic based on the actual temperature.

In step S40, the control unit 50 determines whether it is time to end the measurement. The control unit 50 determines that it is time to end the measurement when it is determined that the corrected temperature reaches a saturated temperature. For example, when the corrected temperature currently calculated in step S35 is higher by a predetermined value or less than the corrected temperature previously calculated in step S35, the control unit 50 determines that the temperature reaches the saturated temperature. The saturated temperature is a temperature when the inclination of the temperature rise characteristic illustrated in FIG. 12 is equal to or less than a predetermined value. After the temperature reaches the saturated temperature, the temperature is almost constant.

The control unit 50 performs the process of step S45 when it is determined that the measured temperature reaches the saturated temperature and it is time to end the measurement (YES), and performs the process of step S20 again when it is determined that it is not time to end the measurement (NO). When the processing returns to step S20 after a predetermined time (for example, about 1 ms) passes, the corrected temperature can be calculated at predetermined time intervals, which is preferable.

In step S45, the control unit 50 controls the heating laser beam source so as to stop the irradiation with the heating laser beam, and then performs the process of step S50. In step S50, the control unit 50 controls the first correcting laser beam source and the second correcting laser beam source so as to stop the irradiation with the first correcting laser beam and the second correcting laser beam, and then perform the process of step S55.

In step S55, the control unit 50 determines the state of the measurement object based on the temperature rise characteristic that is based on the corrected temperature determined in step S60, displays the determination result on a display device or the like, and then finishes the processing. FIG. 13 illustrates an example of the temperature rise characteristic (indicated by a dotted line in FIG. 13) when the area of the bonding part 96 in FIG. 1 is equal to an ideal area, an example of the temperature rise characteristic (indicated by an alternate long and short dash line in FIG. 13) when the area of the bonding part 96 is equal to a lower-limit area, and an example of the temperature rise characteristic (indicated by an alternate long and two short dashes line in FIG. 13) when the area of the bonding part 96 is equal to an upper-limit area. For example, the lower-limit-area temperature rise characteristic when the area of the bonding part 96 is equal to the lower-limit area and the upper-limit area temperature rise characteristic when the area of the bonding part 96 is equal to the upper-limit area are stored in the storage unit.

In step S55, the control unit 50 determines whether the temperature rise characteristic, which is determined based on the corrected temperature, lies between the lower-limit-area temperature rise characteristic and the upper-limit area temperature rise characteristic stored in the storage unit. When the temperature rise characteristic lies between the lower-limit-area temperature rise characteristic and the upper-limit area temperature rise characteristic, it is determined that the bonding state is appropriate. When the temperature rise characteristic does not lie between the lower-limit-area temperature rise characteristic and the upper-limit area temperature rise characteristic, it is determined that the bonding state is inappropriate. When the temperature rise characteristic, which is determined based on the corrected temperature, lies between the lower-limit-area temperature rise characteristic and the upper-limit area temperature rise characteristic, the area of the bonding part is between the lower-limit area and the upper-limit area, that is, the area of the bonding part is in an allowable range.

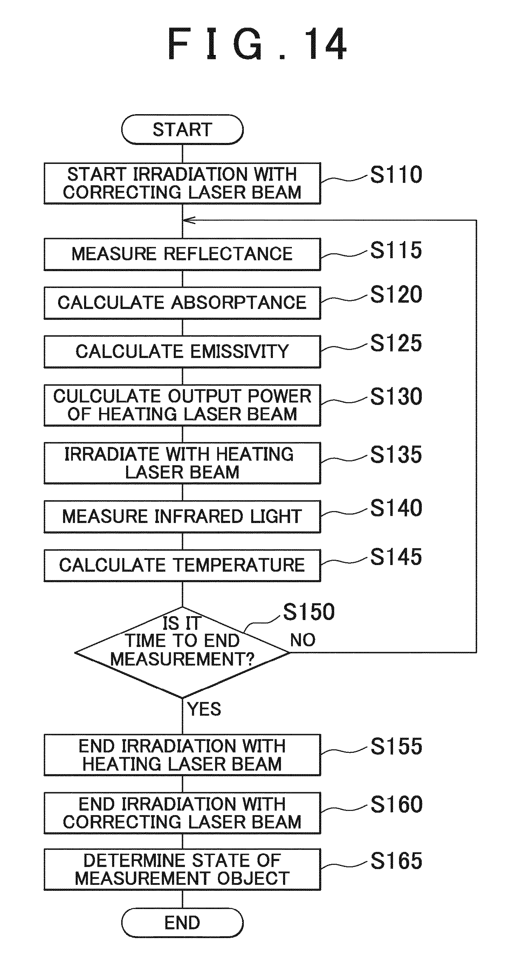

The procedure of second processing performed by the control unit 50 will be described below with reference to the flowchart illustrated in FIG. 14. The configuration of the optical non-destructive inspection apparatus may be the same as that in any one of the first to seventh embodiments. In the procedure of the first processing, the measured infrared energy is corrected on the basis of the reflectance and the temperature rise characteristic is determined on the basis of the corrected temperature calculated from the corrected infrared energy and the time after the heating is started. However, in the processing of the second processing to be described below, the output power of the heating laser beam is adjusted (increased) on the basis of the reflectance so that the measured infrared energy is equal to the corrected infrared energy.

In step S110, the control unit 50 controls the first correcting laser beam source and the second correcting laser beam source so that the first correcting laser beam is emitted from the first correcting laser beam source and the second correcting laser beam is emitted from the second correcting laser beam source, and then performs the process of step S115. The first correcting laser beam and the second correcting laser beam are guided to the measurement spot, the first correcting laser beam reflected from the measurement spot is guided to the first correcting laser detector, and the second correcting laser beam reflected from the measurement spot is guided to the second correcting laser detector.

In step S115, the control unit 50 measures the reflectance of the measurement spot on the basis of the detection signal from the first correcting laser detector and the detection signal from the second correcting laser detector, and then performs the process of step S120. The method of measuring the reflectance is the same that described above.

In step S120, the control unit 50 calculates absorptance from the reflectance measured in step S115, and then performs the process of step S125. Specifically, the absorptance is calculated on the basis of the relationship of absorptance (%) = 100 (%) - reflectance (%). In step S125, the control unit 50 calculates emissivity from the absorptance calculated in step S120, and then performs the process of step S130. Specifically, the emissivity is calculated on the basis of the relationship of absorbance (%) = emissivity (%).

In step S130, the control unit 50 calculates an output value to be output from the heating laser beam source on the basis of the absorptance calculated in step S120, and then performs the process of step S135. For example, in a case where it is estimated, from the relationship with the absorptance, that the infrared energy E1 in FIG. 11 is detected if the heating laser beam with output power of W1 is emitted, the output power W1h of the heating laser beam is calculated on the basis of the absorptance so that the detected infrared energy becomes E1h.

In step S135, the control unit 50 controls the heating laser beam source so that the heating laser beam with the output value calculated in step S 130 is emitted, and then performs the process of step S140. In step S140, the control unit 50 detects the energy of the infrared light beam with the predetermined infrared wavelength λ1 on the basis of the detection signal from the infrared detector, acquires and stores the detected energy of the infrared light beam with the predetermined infrared wavelength λ1 and the time after the irradiation with the heating laser beam is started, and then performs the process of step S145. In step S145, the control unit 50 determines the temperature (actual temperature) corresponding to the acquired infrared energy, and determines the temperature rise characteristic on the basis of the determined actual temperature and the time after the irradiation is started, and then performs the process of step S150. In this case, since the output power of the heating laser beam is adjusted (increased) on the basis of the absorptance, the determined actual temperature can be used for determining the "correct" temperature rise characteristic.

In step S150, the control unit 50 determines whether it is time to end the measurement. As described above, the control unit 50 determines that it is time to end the measurement when it is determined that the determined temperature reaches a saturated temperature. The control unit 50 performs the process of step S 155 when it is determined that the determined temperature reaches the saturated temperature and it is time to end the measurement (YES), and performs the process of step S115 again when it is determined that it is not time to end the measurement (NO). When the processing returns to step S115 after a predetermined time (for example, about 1 ms) passes, the actual temperature can be determined at predetermined time intervals, which is preferable.

In step S155, the control unit 50 controls the heating laser beam source so as to stop the irradiation with the heating laser beam, and then performs the process of step S160. In step S160, the control unit 50 controls the first correcting laser beam source and the second correcting laser beam source so as to stop the irradiation with the first correcting laser beam and the second correcting laser beam, and then perform the process of step S165. In step S165, the control unit 50 determines the state of the measurement object on the basis of the temperature rise characteristic that is based on the actual temperature determined in step S145, displays the determination result on a display unit or the like, and ends the processing.

The method of determining the state of the measurement object is the same as that described above. For example, a lower-limit-area temperature rise characteristic when the area of the bonding part 96 is equal to the lower-limit area and an upper-limit-area temperature rise characteristic when the area of the bonding part 96 is equal to the upper-limit area are stored in the storage unit. In step S165, the control unit 50 determines whether the temperature rise characteristic determined on the basis of the actual temperature is present between the lower-limit-area temperature rise characteristic and the upper-limit-area temperature rise characteristic stored in the storage unit as illustrated in FIG. 13. When the temperature rise characteristics of the measurement object lies between the lower-limit-area temperature rise characteristic and the upper-limit-area temperature rise characteristic, it is determined that the bonding state is appropriate. When the temperature rise characteristic does not lie between the lower-limit-area temperature rise characteristic and the upper-limit-area temperature rise characteristic, it is determined that the bonding state is inappropriate. The control unit 50 displays the determination result. If the temperature rise characteristic determined on the basis of the actual temperature is present between the lower-limit-area temperature rise characteristic and the upper-limit-area temperature rise characteristic, the area of the bonding part lies between the lower-limit area and the upper-limit area, that is, the area of the bonding part is in an allowable range.

A method in which the procedure of the first processing or the second processing is performed using the above-mentioned optical non-destructive inspection apparatus according to each of the first to seventh embodiments may be used as an optical non-destructive inspection method for determining the state of the bonding structure 97 as a measurement object or the bonding state of two members (the wire 93 and the electrode 92) or determining whether the area of the bonding part of two members (the wire 93 and the electrode 92) is in an allowable range, by using a control unit.

Since the optical non-destructive inspection apparatus described in each of the above-mentioned embodiments determines the state of the measurement object using the temperature rise characteristic in a period of several tens of ms until the temperature reaches the saturated temperature after the heating is started with the heating laser beam, the inspection time is extremely short as compared to the case (several tens of seconds to several minutes) in which the state is determined using the heat-dissipation state after heating. As compared to the case where only a correcting laser beam with one type of wavelength is used, the reflectance can be more accurately measured, and therefore, it is possible to more accurately correct the energy of the infrared light beam and to determine a more accurate temperature. Further, since the reflectance of the measurement spot is measured by detecting the first and second correcting laser beams themselves reflected from the measurement spot without heating the measurement spot with the first and second correcting laser beams, and the temperature is corrected on the basis of the measured reflectance, it is possible to obtain a more accurate temperature rise characteristic.

Since the wavelength of the infrared light beam to be measured can be selected from among options in a broad range, it is possible to measure a broader temperature range by selecting an appropriate wavelength of the infrared light beam. The above-mentioned embodiments can be used to determine whether the bonding state of a wire bonding portion or the like is appropriate, and it is possible to perform inspection with higher reliability, as compared to visual inspection by an operator, destructive inspection using an extracted sample, or the like.

Various modifications, additions, and deletions may be made to the configuration, structure, appearance, shape, processing procedure, and the like of the optical non-destructive inspection apparatus and an optical non-destructive inspection method according to the present invention without departing from the scope of the present invention.

## Claims

1. An optical non-destructive inspection apparatus comprising:
a focusing-collimating unit that emits parallel light, which is incident from a first side along an optical axis, from a second side, focuses the parallel light to a measurement spot set on a measurement object as a focal position, converts light, which is emitted and reflected from the measurement spot and incident from the second side, into parallel light along the optical axis, and emits the parallel light from the first side;
a heating laser beam source that emits a heating laser beam for heating the measurement object without destroying the measurement object;
a heating laser beam guide unit that guides the heating laser beam to the first side of the focusing-collimating unit;
an infrared detector that detects an infrared light beam emitted from the measurement spot;
an emitted-infrared guide unit that guides an infrared light beam with a predetermined infrared wavelength out of the parallel light emitted from the measurement spot and emitted from the first side of the focusing-collimating unit, to the infrared detector;
a first correcting laser beam source that emits a first correcting laser beam having output power smaller than that of the heating laser beam, and having a first correcting laser wavelength different from a heating laser wavelength of the heating laser beam;
a first correcting laser beam guide unit that guides the first correcting laser beam emitted from the first correcting laser beam source to the first side of the focusing-collimating unit;
a first correcting laser detector that detects the first correcting laser beam reflected by the measurement spot;
a first reflected laser beam guide unit that guides the first correcting laser beam reflected by the measurement spot and emitted from the first side of the focusing-collimating unit, to the first correcting laser detector;
a second correcting laser beam source that emits a second correcting laser beam having output power smaller than that of the heating laser beam, and having a second correcting laser wavelength different from the heating laser wavelength of the heating laser beam;
a second correcting laser beam guide unit that guides the second correcting laser beam emitted from the second correcting laser beam source to the first side of the focusing-collimating unit;
a second correcting laser detector that detects the second correcting laser beam reflected by the measurement spot;
a second reflected laser beam guide unit that guides the second correcting laser beam reflected by the measurement spot and emitted from the first side of the focusing-collimating unit, to the second correcting laser detector; and
a control unit,
wherein the control unit controls the heating laser beam source, the first correcting laser beam source, and the second correcting laser beam source, measures a temperature rise characteristic based on a detection signal from the infrared detector, a detection signal from the first correcting laser detector, and a detection signal from the second correcting laser detector, and determines a state of the measurement object based on the measured temperature rise characteristic, the temperature rise characteristic being a temperature rise state of the measurement spot based on a heating time.

2. The optical non-destructive inspection apparatus according to claim 1, wherein the heating laser beam guide unit includes:
a heating laser beam collimating unit that is disposed in vicinity of the heating laser beam source, and converts the heating laser beam emitted from the heating laser beam source into parallel light; and
a heating-laser selective reflection unit that is disposed on the optical axis of the focusing-collimating unit, reflects the heating laser beam to the first side of the focusing-collimating unit, and transmits a light beam with a wavelength different from the heating laser wavelength of the heating laser beam out of the parallel light emitted and reflected from the measurement spot and emitted from the first side of the focusing-collimating unit, or
a heating-laser selective reflection unit that is disposed on the optical axis of the focusing-collimating unit, transmits the heating laser beam to the first side of the focusing-collimating unit, and reflects the light beam with the wavelength different from the heating laser wavelength of the heating laser beam out of the parallel light emitted and reflected from the measurement spot and emitted from the first side of the focusing-collimating unit.

3. The optical non-destructive inspection apparatus according to claim 2, wherein the emitted-infrared guide unit includes:
the heating-laser selective reflection unit;
a predetermined-infrared selective reflection unit disposed in a path of parallel light that is emitted from the first side of the focusing-collimating unit and transmitted or reflected by the heating-laser selective reflection unit and has a wavelength different from the heating laser wavelength of the heating laser beam, the predetermined-infrared selective reflection unit reflecting the infrared light beam with the predetermined infrared wavelength out of the parallel light toward the infrared detector, and transmitting the parallel light with a wavelength different from the predetermined infrared wavelength, or
a predetermined-infrared selective reflection unit disposed in the path of the parallel light that is emitted from the first side of the focusing-collimating unit and transmitted or reflected by the heating-laser selective reflection unit and has the wavelength different from the heating laser wavelength of the heating laser beam, the predetermined-infrared selective reflection unit transmitting the infrared light beam with the predetermined infrared wavelength out of the parallel light toward the infrared detector, and reflecting the parallel light with the wavelength different from the predetermined infrared wavelength; and
an infrared focusing unit that is disposed in vicinity of the infrared detector, and focuses the infrared light beam with the predetermined infrared wavelength reflected or transmitted by the predetermined-infrared selective reflection unit, to the infrared detector, the infrared light beam with the predetermined infrared wavelength being parallel light.

4. The optical non-destructive inspection apparatus according to claim 3, wherein the first correcting laser beam guide unit includes:
a first correcting laser beam collimating unit that is disposed in vicinity of the first correcting laser beam source, and converts the first correcting laser beam emitted from the first correcting laser beam source into parallel light;
a first beam splitter that reflects a light beam with the first correcting laser wavelength at a first predetermined proportion, transmits the light beam with the first correcting laser wavelength at a second predetermined proportion, and reflects or transmits the first correcting laser beam with the first correcting laser wavelength, which is emitted from the first correcting laser beam source and converted into the parallel light, toward a correcting laser selective reflection unit so that the first correcting laser beam with the first correcting laser wavelength overlaps with parallel light including the first correcting laser beam reflected from the measurement spot and reflected or transmitted by the correcting laser selective reflection unit via the heating-laser selective reflection unit and the predetermined-infrared selective reflection unit;
the correcting laser selective reflection unit disposed in a path of parallel light that is reflected from the measurement spot and transmitted or reflected by the predetermined-infrared selective reflection unit and has a wavelength different from the predetermined infrared wavelength, the correcting laser selective reflection unit reflecting parallel light with the first correcting laser wavelength emitted from the first correcting laser beam source and reflected or transmitted by the first beam splitter, toward the predetermined-infrared selective reflection unit so that the parallel light with the first correcting laser wavelength overlaps with parallel light with a wavelength different from the predetermined infrared wavelength, and transmitting parallel light with a wavelength different from the first correcting laser wavelength, or
the correcting laser selective reflection unit disposed in the path of the parallel light that is transmitted or reflected by the predetermined-infrared selective reflection unit and has the wavelength different from the predetermined infrared wavelength, the correcting laser selective reflection unit transmitting the parallel light with the first correcting laser wavelength emitted from the first correcting laser beam source and reflected or transmitted by the first beam splitter, toward the predetermined-infrared selective reflection unit so that the parallel light with the first correcting laser wavelength overlaps with parallel light with the wavelength different from the predetermined infrared wavelength, and reflecting the parallel light with the wavelength different from the first correcting laser wavelength;
the predetermined-infrared selective reflection unit; and
the heating-laser selective reflection unit, and
wherein the first reflected laser beam guide unit includes:
the heating-laser selective reflection unit;
the predetermined-infrared selective reflection unit;
the correcting laser selective reflection unit;
the first beam splitter; and
a first reflected laser beam focusing unit that is disposed in vicinity of the first correcting laser detector, and focuses parallel light with the first correcting laser wavelength reflected from the measurement spot and transmitted or reflected by the first beam splitter in a direction different from a direction toward the first correcting laser beam source, to the first correcting laser detector.

5. The optical non-destructive inspection apparatus according to claim 4, wherein the second correcting laser beam guide unit includes:
a second correcting laser beam collimating unit that is disposed in vicinity of the second correcting laser beam source, and converts the second correcting laser beam emitted from the second correcting laser beam source into parallel light;
a second beam splitter that reflects a light beam with the second correcting laser wavelength at a third predetermined proportion, transmits the light beam with the second correcting laser wavelength at a fourth predetermined proportion, and reflects or transmits the second correcting laser beam with the second correcting laser wavelength, which is emitted from the second correcting laser beam source and converted into the parallel light, toward the correcting laser selective reflection unit so that the second correcting laser beam with the second correcting laser wavelength overlaps with parallel light including the second correcting laser beam reflected from the measurement spot and transmitted or reflected by the correcting laser selective reflection unit via the heating-laser selective reflection unit and the predetermined-infrared selective reflection unit;
the correcting laser selective reflection unit;
the predetermined-infrared selective reflection unit; and
the heating-laser selective reflection unit, and
wherein the second reflected laser beam guide unit includes:
the heating-laser selective reflection unit;
the predetermined-infrared selective reflection unit;
the correcting laser selective reflection unit;
the second beam splitter; and
a second reflected laser beam focusing unit that is disposed in vicinity of the second correcting laser detector, and focuses parallel light with the second correcting laser wavelength reflected from the measurement spot and transmitted or reflected by the second beam splitter in a direction different from a direction toward the second correcting laser beam source, to the second correcting laser detector.

6. The optical non-destructive inspection apparatus according to claim 2, wherein the first correcting laser beam guide unit includes:
a first correcting laser beam collimating unit that is disposed in vicinity of the first correcting laser beam source, and converts the first correcting laser beam emitted from the first correcting laser beam source into parallel light;
a first beam splitter that reflects a light beam with the first correcting laser wavelength at a first predetermined proportion, transmits the light beam with the first correcting laser wavelength at a second predetermined proportion, and reflects or transmits the first correcting laser beam with the first correcting laser wavelength, which is emitted from the first correcting laser beam source and converted into parallel light, toward a correcting laser selective reflection unit so that the first correcting laser beam with the first correcting laser wavelength overlaps with parallel light including the first correcting laser beam reflected from the measurement spot and reflected or transmitted by the correcting laser selective reflection unit via the heating-laser selective reflection unit;
the correcting laser selective reflection unit disposed in a path of parallel light that is reflected from the measurement spot and transmitted or reflected by the heating-laser selective reflection unit and has a wavelength different from the heating laser wavelength, the correcting laser selective reflection unit reflecting parallel light with the first correcting laser wavelength emitted from the first correcting laser beam source and reflected or transmitted by the first beam splitter, toward the heating-laser selective reflection unit so that the parallel light with the first correcting laser wavelength overlaps with parallel light with a wavelength different from the heating laser wavelength, and transmitting parallel light with a wavelength different from the first correcting laser wavelength, or
the correcting laser selective reflection unit disposed in the path of the parallel light that is reflected from the measurement spot and transmitted or reflected by the heating-laser selective reflection unit and has the wavelength different from the heating laser wavelength, the correcting laser selective reflection unit transmitting the parallel light with the first correcting laser wavelength emitted from the first correcting laser beam source and reflected or transmitted by the first beam splitter, toward the heating-laser selective reflection unit so that the parallel light with the first correcting laser wavelength overlaps with the parallel light with the wavelength different from the heating laser wavelength, and reflecting the parallel light with the wavelength different from the first correcting laser wavelength; and
the heating-laser selective reflection unit, and
wherein the first reflected laser beam guide unit includes:
the heating-laser selective reflection unit;
the correcting laser selective reflection unit;
the first beam splitter; and
a first reflected laser beam focusing unit that is disposed in vicinity of the first correcting laser detector, and focuses parallel light with the first correcting laser wavelength reflected from the measurement spot and transmitted or reflected by the first beam splitter in a direction different from a direction toward the first correcting laser beam source, to the first correcting laser detector.

7. The optical non-destructive inspection apparatus according to claim 6, wherein the emitted-infrared guide unit includes:
the heating-laser selective reflection unit;
the correcting laser selective reflection unit;
a predetermined-infrared selective reflection unit disposed in a path of parallel light that is emitted from the first side of the focusing-collimating unit and transmitted by the heating-laser selective reflection unit and the correcting laser selective reflection unit and has a wavelength different from the heating laser wavelength and the first correcting laser wavelength, the predetermined-infrared selective reflection unit reflecting the infrared light beam with the predetermined infrared wavelength out of the parallel light, toward the infrared detector, and transmitting parallel light with a wavelength different from the predetermined infrared wavelength; or
a predetermined-infrared selective reflection unit disposed in the path of the parallel light that is emitted from the first side of the focusing-collimating unit and transmitted by the heating-laser selective reflection unit and the correcting laser selective reflection unit and has the wavelength different from the heating laser wavelength and the first correcting laser wavelength, the predetermined-infrared selective reflection unit transmitting the infrared light beam with the predetermined infrared wavelength out of the parallel light, toward the infrared detector, and reflecting the parallel light with the wavelength different from the predetermined infrared wavelength; and
an infrared focusing unit that is disposed in vicinity of the infrared detector, and focuses the infrared light beam with the predetermined infrared wavelength reflected or transmitted by the predetermined-infrared selective reflection unit, to the infrared detector, the infrared light beam being parallel light.

8. The optical non-destructive inspection apparatus according to claim 7, wherein the second correcting laser beam guide unit includes:
a second correcting laser beam collimating unit that is disposed in vicinity of the second correcting laser beam source, and converts the second correcting laser beam emitted from the second correcting laser beam source into parallel light;
a second beam splitter that reflects a light beam with the second correcting laser wavelength at a third predetermined proportion, transmits the light beam with the second correcting laser wavelength at a fourth predetermined proportion, and reflects or transmits the second correcting laser beam with the second correcting laser wavelength, which is emitted from the second correcting laser beam source and converted into the parallel light, toward the correcting laser selective reflection unit so that the second correcting laser beam with the second correcting laser wavelength overlaps with parallel light including the second correcting laser beam reflected from the measurement spot and transmitted or reflected by the predetermined-infrared selective reflection unit via the heating-laser selective reflection unit and the correcting laser selective reflection unit;
the predetermined-infrared selective reflection unit;
the correcting laser selective reflection unit; and
the heating-laser selective reflection unit, and
wherein the second reflected laser beam guide unit includes:
the heating-laser selective reflection unit;
the correcting laser selective reflection unit;
the predetermined-infrared selective reflection unit;
the second beam splitter; and
a second reflected laser beam focusing unit that is disposed in vicinity of the second correcting laser detector, and focuses parallel light with the second correcting laser wavelength transmitted or reflected by the second beam splitter in a direction different from a direction toward the second correcting laser beam source, to the second correcting laser detector.

9. The optical non-destructive inspection apparatus according to any one of claims 1 to 8, wherein one of the first correcting laser wavelength and the second correcting laser wavelength is set to a wavelength longer than the heating laser wavelength of the heating laser beam and the other is set to a wavelength shorter than the heating laser wavelength of the heating laser beam.

10. The optical non-destructive inspection apparatus according to any one of claims 1 to 9, wherein the control unit
acquires the detection signal from the infrared detector while controlling the heating laser beam source so as to heat the measurement spot with the heating laser beam,
acquires the detection signal from the first correcting laser detector and the detection signal from the second correcting laser detector while controlling the first correcting laser beam source and the second correcting laser beam source so as to irradiate the measurement spot with the first correcting laser beam and the second correcting laser beam,
measures a reflectance of the measurement spot based on the detection signal acquired from the first correcting laser detector and the detection signal acquired from the second correcting laser detector,
corrects a detected value acquired from the infrared detector based on the measured reflectance,
determines a temperature based on the corrected detected value, and
determines the state of the measurement object based on the temperature rise characteristic that is based on the determined temperature and the heating time.

11. The optical non-destructive inspection apparatus according to any one of claims 1 to 9, wherein the control unit
acquires the detection signal from the first correcting laser detector and the detection signal from the second correcting laser detector while controlling the first correcting laser beam source and the second correcting laser beam source so as to irradiate the measurement spot with the first correcting laser beam and the second correcting laser beam,
measures a reflectance of the measurement spot based on the detection signal acquired from the first correcting laser detector and the detection signal acquired from the second correcting laser detector,
adjusts output power of the heating laser beam from the heating laser beam source based on the measured reflectance,
acquires the detection signal from the infrared detector while heating the measurement spot with the heating laser beam whose output power has been adjusted,
determines a temperature based on the detection signal acquired from the infrared detector, and
determines the state of the measurement object based on the temperature rise characteristic that is based on the determined temperature and the heating time.

12. The optical non-destructive inspection apparatus according to any one of claims 1 to 11,
wherein the measurement object is a bonding structure including a bonding part in which two members are bonded,
wherein the measurement spot is set on a surface of one member of the two members, and
wherein the control unit determines a bonding state of the two members based on the temperature rise characteristic.

13. The optical non-destructive inspection apparatus according to claim 12,
wherein the bonding state of the two members to be determined is a magnitude of an area of the bonding part of the two members, and
wherein the control unit determines whether the area of the bonding part of the two members is in an allowable range, based on the temperature rise characteristic.

14. An optical non-destructive inspection method,
wherein the optical non-destructive inspection apparatus according to any one of claims 1 to 13 is used, and
wherein the state of the measurement object is determined by the control unit.
